(19) Europäisches Patentamt
European Patent Office
Office européen des brevets

(11) **EP 3 086 470 B1**

(12) **EUROPÄISCHE PATENTSCHRIFT**

(45) Veröffentlichungstag und Bekanntmachung des Hinweises auf die Patenterteilung:
**25.10.2017   Patentblatt 2017/43**

(51) Int Cl.:
*H03H 7/01* $^{(2006.01)}$

(21) Anmeldenummer: **16162141.2**

(22) Anmeldetag: **24.03.2016**

(54) **VERFAHREN ZUM ERSTELLEN EINER KOPPELMATRIX ZUM ABSTIMMEN VON FILTERN UND VORRICHTUNG ZUM ABSTIMMEN VON FILTERN**

METHOD FOR CREATING A COUPLING MATRIX FOR TUNING FILTERS AND DEVICE FOR TUNING FILTERS

PROCÉDÉ DE FABRICATION D'UNE MATRICE DE COUPLAGE DESTINÉE À L'ACCORD DES FILTRES ET DISPOSITIF D'ACCORD DE FILTRES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.04.2015   DE 102015207243**

(43) Veröffentlichungstag der Anmeldung:
**26.10.2016   Patentblatt 2016/43**

(73) Patentinhaber: **Airbus Defence and Space GmbH 85521 Ottobrunn (DE)**

(72) Erfinder: **PFLÜGER, Stefan 81379 München (DE)**

(74) Vertreter: **Isarpatent Patent- und Rechtsanwälte Behnisch Barth Charles Hassa Peckmann & Partner mbB Friedrichstrasse 31 80801 München (DE)**

(56) Entgegenhaltungen:
• S. AMARI ET AL: "Adaptive synthesis and design of resonator filters with source/load-multiresonator coupling", IEEE TRANSACTIONS ON MICROWAVE THEORY AND TECHNIQUES., Bd. 50, Nr. 8, 1. August 2002 (2002-08-01) , Seiten 1969-1978, XP055300538, US ISSN: 0018-9480, DOI: 10.1109/TMTT.2002.801348

• SMAIN AMARI: "Synthesis of Cross-Coupled Resonator Filters Using an Analytical Gradient-BasedOptimization Technique", IEEE TRANSACTIONS ON MICROWAVE THEORY AND TECHNIQUES, IEEE SERVICE CENTER, PISCATAWAY, NJ, US, Bd. 48, Nr. 9, 1. September 2000 (2000-09-01), XP011038055, ISSN: 0018-9480

• MAHBOUBEH ESMAEILI ET AL: "Diagnosis and tuning of multiple coupled resonator filters", ELECTRICAL ENGINEERING (ICEE), 2010 18TH IRANIAN CONFERENCE ON, IEEE, PISCATAWAY, NJ, USA, 11. Mai 2010 (2010-05-11), Seiten 124-129, XP031706878, ISBN: 978-1-4244-6760-0

• KOZAKOWSKI P ET AL: "Eigenvalue Approach to Synthesis of Prototype Filters With Source/Load Coupling", IEEE MICROWAVE AND WIRELESS COMPONENTS LETTERS, IEEE SERVICE CENTER, NEW YORK, NY, US, Bd. 15, Nr. 2, 1. Februar 2005 (2005-02-01), Seiten 98-100, XP011126445, ISSN: 1531-1309, DOI: 10.1109/LMWC.2004.842838

• GARCIA-LAMPEREZ A ET AL: "Efficient electromagnetic optimization of microwave filters and multiplexers using rational models", IEEE TRANSACTIONS ON MICROWAVE THEORY AND TECHNIQUES, IEEE SERVICE CENTER, PISCATAWAY, NJ, US, Bd. 52, Nr. 2, 1. Februar 2004 (2004-02-01), Seiten 508-521, XP011506756, ISSN: 0018-9480, DOI: 10.1109/TMTT.2003.822021

• ALEJANDRO GARCIA-LAMPEREZ ET AL: "Fast direct electromagnetic optimization of a microwave filter without diagonal cross-couplings through model extraction", MICROWAVE CONFERENCE, 2003. 33RD EUROPEAN, IEEE, 2. Oktober 2003 (2003-10-02), Seiten 1361-1364, XP032392034, DOI: 10.1109/EUMA.2003.340873 ISBN: 978-1-58053-834-3

**Beschreibung**

Die vorliegende Anmeldung betrifft eine Vorrichtung zum Abstimmen (Tunen) von Filtern und entsprechende Verfahren. Insbesondere beschreibt die vorliegende Anmeldung ein Verfahren, mit dem eine Koppelmatrix mit weniger Zeit- und Rechenaufwand erstellt werden kann. Die so erstellte Koppelmatrix kann die physikalische Struktur eines abzustimmenden Filters sehr genau wiedergeben.

Viele kommerziell eingesetzte Resonator-Filter, u.a. Hohlleiterfilter, müssen nach der Fertigung oder im Betrieb, wie z.B. Adaptive Filter für Kognitive-Radio-Anwendungen, abgestimmt werden, damit sie die vorgegebenen Spezifikationen erfüllen. Die Aufgabe der Abstimmung (Tuning) besteht in der Einstellung der Kopplungen und Resonanzfrequenzen der Resonatoren. Aufgrund der Komplexität des Zusammenwirkens dieser Parameter ist die Abstimmung schwierig und bislang mit hohem Zeit-/Rechenaufwand verbunden. Bekannte Ansätze zur Abstimmung von Filtern haben insbesondere Nachteile im Hinblick auf den Aufwand, der für die Abstimmung oder die Vorbereitung der Abstimmungsvorrichtungen notwendig ist, der Konvergenz und/oder der Abbildung der physikalischen Struktur des Filters mittels Koppelmatrizen.

Es existieren Ansätze für das Abstimmen bzw. den Abgleich von Filtern, die auf neuralen Netzen basieren, die auf die abzugleichende Struktur trainiert wurden. Beispielsweise beschreibt J. J. Michalski "Artificial Neural Networks Approach in Microwave Filter Tuning", Progress In Electromagnetics Research M, Vol. 13, 2010 einen solchen Ansatz. Die so vorab trainierten Vorrichtungen bzw. neuronalen Netze sind dann allerdings nur für die trainierte Struktur anwendbar, so dass deren Flexibilität im Hinblick auf verschiedene Filterstrukturen stark eingeschränkt ist oder sogar keine Flexibilität vorhanden ist. Ferner wäre es wünschenswert, den Aufwand für die vorab durchzuführenden Trainings einsparen zu können.

Ferner sind Verfahren zur Abstimmung von Filtern bekannt, die den Ansatz einer Parameterextraktion aus Messdaten verwenden, wie z.B. US 2006/202775 A1 und US 2009/121802 A1. Die dabei verwendeten Optimierungsverfahren haben jedoch Nachteile im Hinblick auf ihre Konvergenzeigenschaft. Amari et al. beschreiben die bekannten Parameterextraxtionen als schwierig handhabbar im Hinblick auf deren Konvergenzeigenschaften (S. Amari et. al.: "Adaptive Synthesis and Design of Resonator Filters with Source/Load-Multiresonator Coupling", IEEE Transcations on Microwave theory and techniques, vol. 50, no. 8, August 2002).

Zwar beschreiben V. Miraftab et. al. robustere Verfahren zur Parameterextraktion ("Generalized lossy microwave filter coupling matrix synthesis and design using mixed technologies" in IEEE Transcations on Microwave theory and techniques, vol. 56, no. 12, December 2008), jedoch wird bei diesen Verfahren ein Parametersatz erzeugt, der in seiner Struktur nicht dem physikalischen Aufbau des Filters entspricht bzw. diesen nicht abbildet. Dieser Ansatz kann deshalb alleine nicht für die Filter-Abstimmung herangezogen sein.

In "Adaptive synthesis and design of resonator filters with source/load-multiresonator coupling" wird ein Verfahren zum Synthetisieren von Resonatorfiltern offenbart. In "Synthesis of Cross-Coupled Resonator Filters Using an Analytical Gradient-Based Optimization Technique" wird ebenfalls ein Verfahren zum Synthetisieren von Resonatorfiltern offenbart. In "Diagnosis and tuning of multiple coupled resonator filters" wird ein Verfahren zum Extrahieren einer Kopplungsmatrix in gekoppelten Resonatorfiltern offenbart. In "Eigenvalue Approach to Synthesis of Prototype Filters With Source/Load Coupling" wird ein schnell konvergierendes Verfahren zur Synthese der Kopplungsmatrix bei Chebyshev Filterfunktionen gezeigt. In "Efficient electromagnetic optimization of microwave filters and multiplexers using rational models" wird ein Verfahren zur Optimierung von Mikrowellenfiltern und Multiplexern offenbart. In "Fast direct electromagnetic optimization of a microwave filter without diagonal cross-couplings through model extraction" wird ein Verfahren zur elektromagnetischen Optimierung von passiven Mikrowellenvorrichtungen offenbart.

Es besteht Bedarf für ein Verfahren zur Erstellung einer Koppelmatrix, die für die Abstimmung eines Filters herangezogen werden kann, sowie ein Verfahren, eine entsprechende Vorrichtung und ein entsprechendes Computerprogrammprodukt zur Abstimmung eines Filters basierend auf dieser Koppelmatrix. Das Verfahren sollte gute Konvergenzeigenschaften aufweisen, weniger Rechen- und Zeitaufwand erfordern und eine Koppelmatrix erstellen können, die die physikalische Struktur des Filters möglichst genau abbildet. Im Hinblick auf den Rechen- und Zeitaufwand wäre es insbesondere von Vorteil, wenn das Verfahren kein Training für vorbestimmte Filter benötigt, da dann auch eine bessere Flexibilität im Hinblick auf das Abstimmen verschiedener Filter gegeben ist.

Diese Aufgabe wird von den hier beschriebenen Verfahren gemäß den Ansprüchen 1 und 11, sowie dem Vorrichtungsanspruch 12 und dem Computerprogrammanspruch 13 gelöst. Bevorzugte Weiterentwicklungen werden von den abhängigen Ansprüchen 2-10 beschrieben.

Gemäß einem Aspekt wird hier ein Verfahren zum Erstellen einer angepassten Koppelmatrix eines Filters bzw. zum Abbilden einer physikalischen Struktur eines Filters beschrieben. Das Verfahren kann die Schritte umfassen: Messen von Streuparameterdaten des Filters, Approximation der gemessenen Streuparameterdaten mittels rationaler Funktionen, Erstellen einer ursprünglichen Koppelmatrix basierend auf den rationalen Funktionen und Erstellen einer angepassten Koppelmatrix, die die physikalische Struktur des Filters abbildet, basierend auf der ursprünglichen Koppelmatrix. Der letzte Schritt kann auch als ein Anpassen/Rekonfigurieren der anzupassenden Koppelmatrix auf die physikalische Struktur des Filters bezeichnet werden (die anzupassende Koppelmatrix kann dabei ausgehend von der ursprünglichen Koppelmatrix iterativ angepasst bzw. erstellt werden).

Das Messen der Streuparameterdaten kann umfassen, dass ein abzustimmender (zu "tune"-ender) Filter mittels eines Netzwerkanalysators vermessen wird. Die Streuparameterdaten können besonders bevorzugt als Funktion der Frequenz gemessen werden. Die Streuparameterdaten können beispielsweise die Messwerte eines Zweitor umfassen; aber auch komplexere Schaltungen wiedergeben.

Ein Beispiel für den Schritt der Approximation kann umfassen, dass die Streuparameter beispielsweise in Y-Parameter transformiert werden und diese dann beispielsweise mittels des Verfahrens "vector fitting" weiterverarbeitet werden (das "vector fitting" wird bspw. beschrieben von B. Gustavsen und A. Semlyen, "Rational approximation of frequency domain responses by vector fitting", IEEE Trans. Power Del., vol. 14, no. 3, 1999). Andere Algorithmen bzw. Verfahren können ebenfalls herangezogen werden.

Der Approximation kann zur weiteren Erhöhung der Zuverlässigkeit und Genauigkeit des Verfahrens ein optionaler Schritt "Deembedding der Messdaten" vorgeschaltet werden. Das "Deembeding" wird besonders bevorzugt, wenn die Approximation auf einem Model rationaler Funktionen geringer Ordnung (z.B. kleiner N) durchgeführt wird, da diese Modelle Zeitverzögerungen an den Filtertoren nicht (nicht genau genug) abbilden können; wobei anzumerken ist, dass die Ordnung des rationalen Modells gleich der Ordnung des realen Filters sein sollte, um ein physikalisch sinnvolles Modell zu erhalten. Bei einem Modell mit rationalen Funktionen geringer Ordnung kann mittels des "Deembedings" möglicher Zeitverzögerungen eine Verbesserung der Genauigkeit der Abbildung erreicht werden. Bevorzugt wird das "Deembedding" mit bekannten Verfahren durchgeführt.

Das Erstellen der (ursprünglichen) Koppelmatrix (die im Allgemeinen die physikalische Struktur des vermessenen Filters noch nicht abbildet/wiedergibt) aus den rationalen Funktionen kann auf unterschiedliche Weise erfolgen. Ein bevorzugtes Beispiel für die Erstellung der Koppelmatrix wird beispielsweise von V. Miraftab und M. Yu "Advanced Coupling Matrix and Admittance Function Synthesis Techniques for Dissipative Microwave Filters" in IEEE TRANSACTIONS ON MICROWAVE THEORY AND TECHNIQUES, VOL. 57, NO. 10, pp. 2429-2438 (Oktober 2009) beschrieben. Das Ergebnis ist eine vollständig besetzte Koppelmatrix mit komplexen Werten. Die Realteile der Werte beschreiben dabei kapazitive und induktive Kopplungen der Resonatoren des Filters, genauso wie Selbstkopplungseffekte. Imaginäre Teile der Diagonalelemente beschreiben hingegen Verluste innerhalb der Resonatoren. Jedoch sei an dieser Stelle noch einmal darauf hingewiesen, dass die bis dato erzeugte Koppelmatrix noch nicht die reale Topologie des Filters wiedergibt und deshalb in dieser Hinsicht gemäß dem hier beschriebenen Verfahren noch angepasst bzw. rekonfiguriert wird. Mit anderen Worten erfolgt verfahrensgemäß zunächst der Schritt der Erstellung einer ursprünglichen Koppelmatrix, der dann der Schritt des Anpassens auf die Topologie des vermessenen Filters folgt. Bei der Rekonfiguration bzw. bei der Erstellung der angepassten Koppelmatrix werden die Koppelmatrixwerte der ursprünglichen Koppelmatrix mit den gemessenen Werten korreliert.

Es sei noch einmal festgehalten, dass der Schritt des Erstellens einer Koppelmatrix aus den rationalen Funktionen zunächst eine ursprüngliche Koppelmatrix, nachfolgend mit "L" gekennzeichnet, liefert. Der nachfolgende Schritt der Erstellung bzw. Rekonfiguration bzw. Anpassung liefert dann eine angepasste Koppelmatrix, mit "M" gekennzeichnet, die die physikalische Struktur des Filters wiederspiegelt.

Die angepasste Koppelmatrix wird während der Anpassung/Rekonfiguration verändert, die ursprünglich erstellte Koppelmatrix hingegen nicht. Das Ergebnis des hier beschriebenen Verfahrens ist die angepasste Koppelmatrix ("M"), deren (anfängliche) Strukturabweichung von einer vorgegebenen Struktur iterativ minimiert werden kann.

Die verfahrensgemäße Rekonfiguration bzw. Anpassung der ursprünglichen Koppelmatrix ermöglicht es, dass die physikalische Struktur des Filters sehr genau und mit weniger Zeit- und Rechenaufwand nachgebildet werden kann. Es wird eine gute Konvergenz erreicht. Mit anderen Worten umfasst das hier beschriebene Verfahren die Vorteile, dass die Topologie des Filters sehr genau abgebildet werden kann und eine hohe Konvergenz erreicht wird. Im Übrigen wird der Zeit- und Rechenaufwand für die Anpassung der Koppelmatrix auch dadurch reduziert, dass kein Traningsaufwand oder dergleichen anfällt, der z.B. bei Ansätzen mit neuronalen Netzen erforderlich wird.

Gemäß einem bevorzugten Aspekt kann der Schritt des Erstellens der angepassten Koppelmatrix umfassen, dass eine Strukturabweichung, die eine Abweichung zwischen der angepassten Koppelmatrix (nachfolgend auch nur "Koppelmatrix" im Unterschied zu "ursprüngliche Koppelmatrix") und einer abzubildenden physikalischen Struktur des Filters angibt, iterativ minimiert wird.

Gemäß einem besonders bevorzugten Aspekt kann eine Strukturmatrix vorgegeben werden, die die abzubildende physikalische Struktur des Filters wiedergeben kann. Die Strukturabweichung kann auf Basis der (angepassten) Koppelmatrix und der Strukturmatrix ermittelt werden. Besonders bevorzugt kann die Strukturabweichung aus einer Differenz zwischen (angepasster) Koppelmatrix und Strukturmatrix ermittelt werden. Bei der Iteration wird dabei ganz besonders bevorzugt für jeden Iterationsdurchlauf eine minimierte Strukturabweichung berechnet, wobei jeweils eine weitere Modifikation der angepassten Koppelmatrix herangezogen wird.

Mit anderen Worten kann die Strukturabweichung bevorzugt ein Skalar sein, der eine Differenz zwischen der Koppelmatrix und einer Strukturmatrix bzw. einer Koppelmatrix, die mit der Strukturmatrix verrechnet wurde, angibt.

"Iterative Minimierung" soll besonders bevorzugt umfassen, dass die Strukturabweichung bzw. deren Wert in wiederkehrenden Schleifendurchläufen von Unterschritten der Rekonfiguration minimiert wird - möglichst bevorzugt bis ein globales oder zumindest lokales Minimum gefunden werden konnte.

Beispielsweise kann die Strukturmatrix eine binäre Matrix sein, das heißt so aufgebaut sein, dass sie ausschließlich "0" und "1" als Elementwerte enthält. Die Strukturmatrix kann bevorzugt die bevorzugte und vorbestimmte Matrixstruktur der Koppelmatrix aufweisen. Dabei weist die Strukturmatrix bevorzugt Elemente mit Wert "0" derart platziert auf, dass an dieser Stelle die Elemente der Koppelmatrix während der Rekonfiguration verschwinden.

Mit anderen Worten kann an diesen Stellen der Strukturmatrix eine "1" vorgesehen sein, wo Kopplungen und dgl. der Koppelmatrix erhalten bleiben sollen.

Die Abweichung zwischen dem gewünschten bzw. zu erreichenden physikalischen Aufbau des Filters und der Koppelmatrix wird von dem Strukturabweichungswert wiedergegeben. Dieser Wert gibt somit an, wie gut die aktuelle (während der Iteration) Koppelmatrix der angestrebten, finalen angepassten Koppelmatrix (als gewünschtes Produkt der Iteration/Rekonfiguration) bereits entspricht.

Gemäß einem Aspekt kann die Strukturabweichung mittels $\varepsilon := |M - S \circ M|$ ermittelt werden. Hier bezeichnet der Operator "$\circ$" ein elementweises Produkt (Frobenius-Produkt). Beachtlich ist, dass für die Unterscheidung von aktuellen Werten bzw. aktuellen Matrizen und Werten/Matrizen, die in einem Iterationsdurchlauf vorher oder nachher aktuell sind/waren, ein Index verwendet werden kann. Beispielsweise kann der Index "i" verwendet werden, der bevorzugt eine ganze Zahl aus dem Bereich i = 1, 2, 3, ..., n annehmen kann. Dann kann "i" einen aktuellen Wert oder eine aktuelle Matrix kennzeichnen. Die oben angegebene Gleichung (wie auch die weiteren hier verwendeten Gleichungen) kann entsprechend mit Indizes versehen werden.

Das vorliegende Verfahren erlaubt es somit, dass ein mit wenig Aufwand auswertbarer Qualitätsparameter, die Strukturabweichung, berechnet werden kann, der die Qualität der Koppelmatrix im Hinblick auf die abzubildenden Topologie des Filters anzeigt und der iterativ minimiert werden kann.

Gemäß einem bevorzugten Aspekt kann der Schritt des Erstellens der angepassten Koppelmatrix die folgenden Unterschritte umfassen: Ermitteln einer aktuellen Iterationslösung (oder Modifikation) der angepassten Koppelmatrix M basierend auf einer aktuellen (Modifikation der) Ähnlichkeitstransformationsmatrix Q und der ursprünglichen Koppelmatrix, und/oder Ermitteln einer aktuellen Iterationslösung der Strukturabweichung ε.

Wenn für die aktuellen Werte/Matrizen der Index "i" eingesetzt wird, so wären hier bspw. die Werte $M_i$, $Q_i$ und $\varepsilon_i$ heranzuziehen bzw. zu berechnen. In diesem Fall startete der oben genannte Aspekt besonders bevorzugt von einem Startpunkt mit i = 1. Alle weiteren Berechnungsschritte und/oder (Schleifen-)Durchläufe mit i = 2, 3, 4, etc. der genannten Schritte können sich analog anschließen. Die Koppelmatrix $M_i$ wird während der Iterationen immer weiter modifiziert, um schließlich die gewünschte Minimierung der Strukturabweichung zu erreichen. Konstant und nicht verändert wird hingegen die ursprüngliche Koppelmatrix (bzw. eine matrixzerlegte Untermatrix dieser), die aus den rationalen Funktionen gewonnen wurde und noch nicht die Topologie des Filters wiedergibt.

Nach jedem Durchlauf der genannten Schritte und bevorzugt nach einer oder jeder Ermittlung der aktuellen Strukturabweichung können ein oder mehrere Prüfschritte vorgesehen sein, die das Erreichen/Erfüllen vorbestimmter Abbruchbedingungen prüfen und ggf. den Abbruch bzw. das Ende der Minimierung festlegen. Weiterhin kann nach jedem Schleifendurchlauf ein Schritt zur Erhöhung von i um den Wert "1" vorgesehen sein. Besonders bevorzugt kann dieser Schritt des Erhöhens von i nach dem Prüfvorgang erfolgen. Zusätzliche Schritte zur Erhöhung von i können optional vorgesehen sein.

Ein Vorteil des hier beschriebenen Aspektes des Verfahrens ist, dass die ursprüngliche Koppelmatrix so zerlegt wird, dass die Ähnlichkeitstransformationsmatrix gewonnen werden kann, die dann variiert/modifiziert werden kann. Besonders bevorzugt kann die Ähnlichkeitstransformationsmatrix eine Rotationsmatrix sein. Vorbekannte Verfahren hingegen variieren die ursprünglich erstellte Koppelmatrix selbst, was zu unerwünschten Effekten im Hinblick auf die Streuparameter führt, da diese bei einer Änderung der Koppelmatrix selbst verändert werden, so dass sich der Rechen- und Zeitaufwand erhöht und die Konvergenz schlechter wird. So müssen bei den vorbekannten Verfahren vielfältige Randbedingungen an die Streuparameter während der Optimierung eingehalten werden. Dies ist bei dem hier beschriebenen Verfahren, das die Optimierung der Ähnlichkeitstransformationsmatrix vorsieht, vorteilhafterweise nicht notwendig, da die Streuparameter dabei unverändert bleiben.

Bevorzugt kann die Ähnlichkeitstransformationsmatrix so erstellt werden, dass sie die Eigenschaft aufweist, die gemessenen Streuparameter während der Iteration/Rekonfiguration nicht zu verändern. Mit anderen Worten kann die Anordnung der Filterpole und Nullstellen invariant im Hinblick auf die Modifikation der Ähnlichkeitstransformationsmatrix während der Minimierung der Strukturabweichung sein. Somit kann das hier beschriebene Verfahren besonders vorteilhaft verhindern, dass Streuparameter verändert werden, was u. a. zur Generierung von vielen lokalen Minima führte. Der Aufwand für die Durchführung des Verfahrens kann folglich gesenkt werden und die Konvergenz verbessert werden.

Gemäß einem bevorzugten Aspekt kann das Ermitteln einer aktuellen (Modifikation der) Ähnlichkeitstransformationsmatrix basierend auf einem Gradienten g der vormals aktuellen Ähnlichkeitstransformationsmatrix und einer

vorbestimmten Schrittweite $\delta$ durchgeführt werden. Somit kann die Minimierung der Strukturabweichung mit relativ geringem Rechenaufwand mittels eines Gradientenverfahrens durchgeführt werden. Die Verwendung eines Gradientenverfahrens zur Minimierung der Strukturabweichung ist eine besonders bevorzugte Option des hier beschriebenen Verfahrens. Alternative Verfahren zur Minimierung der Strukturabweichung können allerdings auch herangezogen werden, bspw. kann auch ein genetischer Algorithmus für die Minimierung der Strukturabweichung verwendet werden.

Ganz besonders bevorzugt kann die oben genannte Modifikation der Ähnlichkeitstransformationsmatrix basierend auf einem Gradienten der vormals aktuellen Ähnlichkeitstransformationsmatrix ab einer zweiten Iteration/Durchlauf, d.h. bspw. ab einer Iteration mit i ≥ 2 durchgeführt werden. Mit anderen Worten können die zweite und nachfolgende (Modifikation(en) der) Ähnlichkeitstransformationsmatrizen derart berechnet werden. Für i = 1, d.h. für eine erste Ähnlichkeitstransformationsmatrix, kann bevorzugt ein Startwert vorgegeben werden, d.h. die erste Ähnlichkeitstransformationsmatrix kann abweichend von der unten genannten Gleichung gewonnen werden, z.B. durch eine Matrixzerlegung von L.

Indizes für den Gradienten und die Ähnlichkeitstransformationsmatrizen werden in der unten folgenden Gleichung nicht angegeben, diese können entsprechend der Erhöhung des Iterationsindexes "i" eingesetzt werden. Die neue aktuelle bzw. weitere Modifikation der Ähnlichkeitstransformationsmatrix kann insbesondere so berechnet werden, dass die zuvor gültige Ähnlichkeitstransformationsmatrix und der Gradient dieser zuvor gültigen Ähnlichkeitstransformationsmatrix für die Berechnung herangezogen werden. Somit kann die neue aktuelle Modifikation der Ähnlichkeitstransformationsmatrix besonders bevorzugt mittels der Gleichung $Q_i := Q - \delta \cdot g$ ermittelt werden.

Bevorzugt kann der Parameter $\delta$ frei wählbar sein und eine Schrittweite angeben, die bestimmt wie weit bei einem Iterationsdurchlauf in die Richtung des Gradienten gegangen werden soll. Bevorzugt wird ein Startwert für $\delta$ bereits beim Start des Anpassens der Koppelmatrix vorbestimmt oder eingegeben. Der Gradient wird bevorzugt für jeden Durchlauf neu berechnet, d.h. es kann jeweils ein Schritt zur Berechnung von g während eines Iterationsdurchlaufes vorgesehen sein, der besonders bevorzugt vor der Berechnung der nächsten Modifikation der Ähnlichkeitstransformationsmatrix angeordnet sein kann. Der Gradient g kann optional und alternativ auch als Konstante über die Iterationen hinweg beibehalten werden, wenn dieser nach dem ersten Durchlauf einmal ermittelt worden war. In diesem Fall müssen die betroffenen Gleichungen so angepasst werden, dass eine Konstante für den Gradienten eingesetzt wird. Der konstante Gradient g gemäß der oben genannten optionalen Alternative kann besonders bevorzugt während der Optimierung solange verwendet werden, wie Schritte in Richtung des Gradienten noch zu einer kleineren Strukturabweichung führen. Wenn diese Bedingung nicht mehr erfüllt ist, sollte der Gradient angepasst bzw. neu bestimmt werden.

Die Berechnung des Gradienten $g_i$ erfolgt bevorzugt wie folgt:

$$g_i = \frac{1}{2} Q_i \left( Q_i^T f - f^T Q_i \right), \text{ wobei } f_{m,n} = 2 Spur\left( (M_i - S \circ M_i) \cdot (V - S \circ V) \right) \text{ und } V = Q_i^T L J^{m,n} + J^{n,m} L Q_i.$$

Hier ist beachtlich, dass der Index "i" eingesetzt wurde und kennzeichnet, dass die jeweils aktuellen Werte/Matrizen einzusetzen sind. Ferner bezeichnet $f_{m,n}$ die einzelnen Elemente der Matrix f sind. Somit muss der Unterschritt zur Berechnung von $f_{m,n}$ entsprechend häufig der Anzahl der Elemente von f durchgeführt werden. Bei einer N*N-Matrix z.B. $N^2$-mal. Die Matrix V ist eine Hilfsgröße. L ist die ursprüngliche Koppelmatrix. S ist die Matrix der zu erreichenden physikalischen Filterstruktur. Die Matrix $J^{m,n}$ ist so aufgebaut, dass außer dem m,n-Element, das "1" ist, alle weiteren Elemente "0" sind.

Das oben beschriebene Berechnen eines Gradienten und einer Minimierung der Strukturabweichung basierend auf dem Gradientenverfahren machen es möglich, dass sehr "feinfühlig" nach einem Minimum gesucht werden kann, ohne dass dazu ein großer Rechenaufwand notwendig wäre.

Gemäß einem bevorzugten Aspekt kann das Verfahren weiter umfassen: Vergleichen der aktuellen Iterationslösung der Strukturabweichung $\varepsilon$ mit einem vorbestimmten Grenzwert $\varepsilon_{Grenz}$, und/oder Vergleichen der (aktuellen) Schrittweite $\delta$ mit einem vorbestimmten Grenzwert $\delta_{Grenz}$.

Die obigen Vergleichsschritte können bereits bei i = 1 erfolgen, bevorzugt direkt nach dem Schritt des Ermittelns der aktuellen Strukturabweichung. Die erste Prüfung kann allerdings auch erst erstmals bei i > 1, z.B. i = 2, durchgeführt werden, um zu prüfen, ob die Anpassung der Matrix abgeschlossen werden kann.

Ein vorbestimmter Grenzwert kann beliebig vorgegeben werden. Bevorzugt werden allerdings sehr kleine Werte gesetzt, um eine möglichst hohe Genauigkeit zu gewährleisten. Werte von $\varepsilon_{Grenz} < 10^{-5}$ werden bevorzugt, noch bevorzugter wird $\varepsilon_{Grenz} < 10^{-10}$ gesetzt und ganz besonders bevorzugt wird $\varepsilon_{Grenz} \leq 10^{-12}$ gesetzt.

Das Vergleichen der Schrittweite für den aktuellen Iterationsdurchlauf mit einem vorbestimmten Grenzwert $\delta_{Grenz}$ kann bevorzugt nach jedem Anpassen der Ähnlichkeitstransformationsmatrix bzw. jeder Berechnung der Koppelmatrix M erfolgen. Der Grenzwert für die Schrittweite ist bevorzugt $\delta_{Grenz} < 10^{-1}$, noch bevorzugter wird $\delta_{Grenz} < 10^{-4}$ gesetzt. Ganz besonders bevorzugt wird $\delta_{Grenz} \leq 10^{-5}$ gesetzt.

Der Vorteil des Prüfens der Schrittweite liegt darin, dass lokale Minima identifiziert werden können. So kann die Minimierung der Strukturabweichung auf zumindest zwei unterschiedliche Bedingungen hin beendet werden. Einerseits kann die Minimierung beendet werden, wenn der aktuelle Wert für ε den Grenzwert $\varepsilon_{Grenz}$ unterschreitet. Zusätzlich oder bevorzugt alternativ kann die Minimierung beendet werden, wenn die aktuelle Schrittweite kleiner ist als $\delta_{Grenz}$. Im letzten Fall wird sicher und zuverlässig festgestellt, dass ein lokales Minimum gefunden wurde.

Weiterhin kann das Verfahren ein Abfragen umfassen, ob die aktuelle Strukturabweichung größer ist als die des vorangegangenen Iterationsschrittes, besonders bevorzugt wenn die Strukturabweichung größer als der vorbestimmter Grenzwert ist und/oder die Schrittweite δ größer ist als der vorbestimmte Grenzwert. Ganz besonders bevorzugt werden die beiden Strukturabweichungen des aktuellen und vorangegangenen Durchlaufes miteinander verglichen, wenn sowohl die Strukturabweichung größer als der vorbestimmter Grenzwert ist als auch die Schrittweite δ größer ist als der vorbestimmte Grenzwert. Diese weitere Prüfabfrage kann sicherstellen, dass auch tatsächlich eine Minimierung stattfindet.

Wird bei diesem Abfrageschritt festgestellt, dass der aktuelle Strukturabweichungswert größer als der vorangegangene ist, so kann ein weiterer Unterschritt vorgesehen sein. Dieser kann umfassen, dass "der letzte Schritt rückgängig gemacht" wird, was insbesondere umfassen kann, dass die (letzte, vorangegangene) Anpassung/Modifikation der Ähnlichkeitstransformationsmatrix rückgängig gemacht wird. Bspw. kann dies bedeuten, dass die Ähnlichkeitstransformationsmatrix wieder auf den zuvor gültigen Stand zurückgesetzt wird oder dass die aktuelle Modifikation der Ähnlichkeitstransformationsmatrix mit neuer Schrittweite neu berechnet wird. Besonders bevorzugt kann gleichzeitig mit dem Zurücksetzen der Ähnlichkeitstransformationsmatrix auch die Schrittweite δ angepasst und besonders bevorzugt verkleinert werden. Beispielsweise kann die Schrittweite δ automatisiert verkleinert werden. Es kann bspw. vorgesehen sein, dass die Schrittweite δ automatisch halbiert, um eine Zehnerpotenz reduziert oder auf eine andere Art und Weise verändert wird. Ein manuelles Anpassen kann allerdings auch vorgesehen sein.

Mit anderen Worten kann das Verfahren ein Zurücksetzen der Ähnlichkeitstransformationsmatrix auf den vorangegangenen Iterationsschritt und Verkleinern der Schrittweite δ umfassen, wenn die aktuelle/letzte Strukturabweichung größer ist als die des vorangegangenen Iterationsschrittes. Dies erlaubt es sicherzustellen, dass die Minimierung nicht in die "falsche Richtung" läuft und tatsächlich eine Minimierung der Strukturabweichung erfolgt. Die Sicherheit des Verfahrens im Hinblick auf die Ergebniszuverlässigkeit und die Konvergenz werden somit weiter erhöht.

Bei Verwendung von Indizes zur Unterscheidung der Iterationen kann nach dem Ende der Prüfschritte oder vor dem Start der Berechnung von einer weiteren Iterationslösung der Koppelmatrix besonders bevorzugt ein Schritt vorgesehen sein, der den Indexwert um den Wert "1" erhöht. Zusätzlich oder alternativ können weitere Schritte zur Erhöhung vorgesehen sein. Gemäß einem besonders bevorzugten Aspekt kann ein einzelner Schritt zur Erhöhung des Indexes i um den Wert "1" vor dem Berechnen des neuen Gradienten in einem Durchlauf ab i = 2 vorgesehen sein.

Gemäß einem bevorzugten Aspekt kann die Iteration beendet werden, wenn eine (aktuelle) Strukturabweichung kleiner als der vorbestimmte Grenzwert ist und/oder (besonders bevorzugt wird die "oder"-Option), die (aktuelle) Schrittweite δ kleiner als der vorbestimmte Grenzwert ist. Somit wird das Ende der Minimierung sicher feststellbar festgelegt.

Der Start der Iteration kann gemäß einem bevorzugten Aspekt darauf basieren bzw. die erste Iterationslösung der Koppelmatrix $M_1$ kann mittels einer ersten Ähnlichkeitstransformationsmatrix ermittelt werden, die aus einer Matrixzerlegung der ursprünglichen Koppelmatrix L resultieren kann. Die erste Ähnlichkeitstransformationsmatrix kann die

Form $\begin{bmatrix} 1 & 0 & \dots & 0 & 0 \\ 0 & & & & 0 \\ \vdots & & Q_{INNEN}{}^T & & \vdots \\ 0 & & & & 0 \\ 0 & 0 & \dots & 0 & 1 \end{bmatrix}$ aufweisen.

Dabei ist die Beschreibung der Eingangs- und Ausgangstore des Filters auf die äußersten Zeilen und Spalten verteilt, damit diese bei der Transformation während der Minimierung der Strukturabweichung nicht verändert werden. Die innere Matrix (Submatrix) $Q_{INNEN}$ kann wiederrum eine Ähnlichkeitstransformationsmatrix sein. Die oben angegebene Form der Ähnlichkeitstransformationsmatrix kann die allgemeinste Form angeben, mit der das hier vorgestellte Verfahren so durchführbar ist, dass die Streuparameterwerte während der Minimierung nicht geändert werden. Dadurch kann hier vorteilhaft die gute Konvergenz erreicht werden und gleichzeitig verhindert werden, dass das Verfahren zur Anpassung der Koppelmatrix zu komplexen Rechenoperationen führt und ggf. das Ergebnis nicht genau genug werden könnte.

Die oben angegebene Form der Ähnlichkeitstransformationsmatrix hat zwei bevorzugte Eigenschaften: Die verallgemeinerten Eigenwerte des Matrixbüschels (Matrix pencil) (L, I) bleiben während der Transformation bzw. Matrixzerlegung unverändert. Die Eigenwerte sind gleich den Übertragungspolen des Filters. Diese Eigenschaft wird dadurch erreicht, dass die Ähnlichkeitstransformationsmatrix eine Ähnlichkeitstransformation beschreibt. Ferner bleiben die Übertragungs- und Reflektions"nullen" während der Transformation unverändert. Die Position dieser Nullen wird von den Eigenwerten von entsprechenden Minoren beeinflusst. Diese Eigenschaft wird dadurch erreicht, dass auch die Transformationen der Minore Ähnlichkeitstransformationen sind.

Die oben genannten Eigenschaften der oben angegebenen Ähnlichkeitstransformationsmatrix ermöglichen, dass Filterpole und Nullen nicht geändert werden, wenn die Minimierung durchgeführt wird.

Gemäß einem besonders bevorzugten Aspekt kann die Ermittlung der ersten Iterationslösung der Koppelmatrix $M_1$ mittels der Einheitsmatrix I als erste (Start-)Ähnlichkeitstransformationsmatrix $Q_1$ durchgeführt werden. Die Zerlegung der Koppelmatrix L ergibt dann folglich eine N+2 Koppelmatrix und eine Ähnlichkeitstransformation in Form der Einheitsmatrix I als erste Ähnlichkeitstransformationsmatrix $Q_1$ gemäß $M_i := Q_i^T L Q_i$ mit i = 1 für den Start der Minimierung, $Q_1$ in diesem Fall als die Einheitsmatrix I und L die umzuformende Koppelmatrix bzw. ursprüngliche Koppelmatrix zum Start der Minimierung.

Gemäß einem weiteren besonders bevorzugten Aspekt kann die erste Iterationslösung der Koppelmatrix $M_1$ so ermittelt werden, dass die ursprüngliche Koppelmatrix mittels einer verallgemeinerten Eigenwertzerlegung mit dem Matrix-Büschel (L,I) zerlegt wird, so dass die resultierende Transformationsmatrix die oben angegebenen Form

$$\begin{bmatrix} 1 & 0 & \dots & 0 & 0 \\ 0 & & & & 0 \\ \vdots & & Q_{INNEN}{}^T & & \vdots \\ 0 & & & & 0 \\ 0 & 0 & \dots & 0 & 1 \end{bmatrix} \text{ erhält.}$$

Die Zerlegung und anschließende Änderung der Ähnlichkeitstransformationsmatrix während der Minimierung der Strukturabweichung hat den Vorteil, dass die Streuparameterwerte während der Minimierung nicht geändert werden.

Gemäß einem besonders bevorzugten Aspekt kann nach der Modifikation der Ähnlichkeitstransformationsmatrix eine Orthonormalisierung der modifizierten Ähnlichkeitstransformationsmatrix durchgeführt werden. Dieser bevorzugte weitere Schritt kann verhindern, dass kleine Abweichungen der Ähnlichkeitstransformationsmatrix nach deren Anpassung entlang des Gradienten im Schritt zuvor, ausgeglichen werden können. Besonders bevorzugt wird hier beispielsweise das Gram-Schmidt-Verfahren für die Orthonormalisierung der angepassten Ähnlichkeitstransformationsmatrix durchgeführt. Die Genauigkeit des Verfahrens kann somit weiter erhöht werden.

Gemäß einem besonders bevorzugten Aspekt kann der in den Figuren bezeichnete Schritt S5 die Unterschritte aufweisen (wobei die oben angegeben Gleichungen mit entsprechenden Indizes "i" für die entsprechenden Schritte verwendet werden können): Ermitteln einer ersten Koppelmatrix $M_1$ basierend auf einer vorgegebenen ersten Ähnlichkeitstransformationsmatrix $Q_1$, die die Einheitsmatrix ist, und der ursprünglichen Koppelmatrix aus Schritt S4. Berechnen der ersten Strukturabweichung basierend auf der ersten Koppelmatrix $M_1$. Prüfen (optional), ob die erste Strukturabweichung kleiner ist als ein vorgegebener Grenzwert. Falls nicht, wird ein erster Gradient $g_1$ berechnet und i auf den Wert "2" erhöht. Anschließend wird eine (zweite) Modifikation der Ähnlichkeitstransformationsmatrix $Q_2$ mittels des zuvor berechneten Gradienten und der zuvor gültigen Ähnlichkeitstransformationsmatrix, bei i = 2 ist dies $Q_1$, ermittelt. Optional wird die Modifikation der Ähnlichkeitstransformationsmatrix $Q_2$ orthonormalisiert. Danach wird die weiter geänderte Koppelmatrix $M_i$ (mittels $Q_i$ und der ursprünglichen Koppelmatrix) und die weiter geänderte Strukturabweichung $\varepsilon_i$ berechnet und geprüft, ob die weiter geänderte Strukturabweichung $\varepsilon_i$ kleiner als der vorgegebene Grenzwert ist. Wenn dies nicht der Fall ist, wird geprüft, ob die für die Berechnung der Modifikation der Ähnlichkeitstransformationsmatrix herangezogene Schrittweite klein genug war. Falls dies nicht der Fall ist, wird geprüft, ob der aktuelle Wert der Strukturabweichung größer ist als der zuvor gültige Wert. Falls dies der Fall ist, wird die Ähnlichkeitstransformationsmatrix zurückgesetzt und mit verkleinerter Schrittweite neu berechnet. Falls nicht, wird i um den Wert "1" erhöht und ein weiterer geänderter Wert des Gradienten $g_i$ ermittelt. Weiterhin wird eine weitere Modifikation der Ähnlichkeitstransformationsmatrix $Q_i$ basierend auf $g_i$ und $Q_{i-1}$ (optionalerweise wird $Q_i$ auch orthonormalisiert), eine weiter geänderte Koppelmatrix $M_i$ (mittels $Q_i$ und der ursprünglichen Koppelmatrix) und eine weiter geänderte Strukturabweichung $\varepsilon_i$ mit i = 3 berechnet. Anschließend werden die vorgenannten drei Prüfschritte wiederholt. Falls ein weiterer Durchlauf notwendig werden sollte, wird i wiederrum um den Wert "1" erhöht und es erfolgt ein Start bei der Neuberechnung des weiter geänderten Gradienten $g_i$ mit den nachfolgenden Schritten wie oben beschrieben.

Es sei angemerkt, dass die Prüfungsschritte auch abweichend vorgesehen sein können, z.B. in einer abweichenden Reihenfolge. Beispielsweise kann zunächst die Schrittweite geprüft werden, bevor die Strukturabweichung mit einem Grenzwert verglichen wird.

Ein weiterer besonders bevorzugter Aspekt des in den Figuren bezeichneten Schrittes S5 kann die Unterschritte umfassen (wobei die oben angegeben Gleichungen mit entsprechenden Indizes "i" für die entsprechenden Schritte verwendet werden können): Ermitteln einer ersten Koppelmatrix $M_1$ basierend auf einer vorgegebenen ersten Ähnlichkeitstransformationsmatrix $Q_1$, die die Einheitsmatrix ist, und der ursprünglichen Koppelmatrix aus Schritt S4. Berechnen der ersten Strukturabweichung basierend auf der ersten Koppelmatrix $M_1$. und eines ersten Gradienten $g_1$. Anschließend wird eine (zweite) Modifikation der Ähnlichkeitstransformationsmatrix $Q_{i+1=2}$ mittels des zuvor berechneten Gradienten und der zuvor gültigen Ähnlichkeitstransformationsmatrix $Q_i$ ermittelt. Optional wird die Modifikation der Ähnlichkeits-

transformationsmatrix $Q_2$ orthonormalisiert. Danach wird die weiter geänderte Koppelmatrix $M_{i+1}$ (mittels $Q_{i+1}$ und der ursprünglichen Koppelmatrix) und die weiter geänderte Strukturabweichung $\varepsilon_{i+1}$ berechnet und geprüft, ob die weiter geänderte Strukturabweichung $\varepsilon_{i+1}$ kleiner als der vorgegebene Grenzwert ist. Wenn dies nicht der Fall ist, wird geprüft, ob die für die Berechnung der Modifikation der Ähnlichkeitstransformationsmatrix herangezogene Schrittweite klein genug war. Falls dies nicht der Fall ist, wird geprüft, ob der aktuelle Wert der Strukturabweichung größer ist als der zuvor gültige Wert. Falls dies der Fall ist, wird die Ähnlichkeitstransformationsmatrix zurückgesetzt und mit verkleinerter Schrittweite neu berechnet. Falls nicht, wird i um den Wert "1" erhöht und ein weiterer geänderter Wert des Gradienten $g_i$ ermittelt. Weiterhin wird eine weitere Modifikation der Ähnlichkeitstransformationsmatrix $Q_{i+1}$ basierend auf $g_i$ und $Q_i$ (optionalerweise wird $Q_{i+1}$ auch orthonormalisiert), eine weiter geänderte Koppelmatrix $M_{i+1}$ (mittels $Q_{i+1}$ und der ursprünglichen Koppelmatrix) und eine weiter geänderte Strukturabweichung $\varepsilon_{i+1}$ mit i = 2 berechnet. Anschließend werden die vorgenannten drei Prüfschritte wiederholt. Falls ein weiterer Durchlauf notwendig werden sollte, wird i wiederrum um den Wert "1" erhöht und es erfolgt ein Start bei der Neuberechnung des weiter geänderten Gradienten $g_i$ mit den nachfolgenden Schritten wie oben beschrieben.

Gemäß einem weiteren bevorzugten Aspekt kann hier auch ein Verfahren zum Abstimmen eines Filters vorgesehen sein, das die angepasste Koppelmatrix verwenden kann, um den Filter abzustimmen (zu "tunen"), die mittels eines Verfahrens nach zumindest einem der voranstehenden Aspekte erstellt wurde. Besonders bevorzugt können die oben erläuterten Verfahrensaspekte zum Abstimmen eines Filters folglich in ein Verfahren eingegliedert sein, das die Koppelmatrix nach der Abstimmung zum Einstellen/Abstimmen eines Filters heranzieht.

Gemäß einem weiteren Aspekt kann eine Vorrichtung zum Erstellen einer angepassten Koppelmatrix eines Filters und/oder zum Abstimmen eines Filters mittels einer angepassten Koppelmatrix hier vorgesehen sein. Die Vorrichtung zum Erstellen der angepassten Koppelmatrix kann aufweisen: ein oder mehr Mittel zum Messen von Streuparameterdaten des Filters, ein oder mehr Mittel zum Approximieren der gemessenen Streuparameterdaten mittels rationaler Funktionen, ein oder mehr Mittel zum Erstellen der ursprünglichen Koppelmatrix basierend auf den rationalen Funktionen und/oder zum Erstellen der angepassten Koppelmatrix (die auf die physikalische Struktur des Filters angepasst ist). Die Vorrichtung zum Tunen des Filters kann die Vorrichtung zum Erstellen der angepassten Koppelmatrix und ein oder mehr Mittel zum Abstimmen des Filters basierend auf der angepassten Koppelmatrix aufweisen. Das Mittel zum Abstimmen des Filters kann beispielsweise eine Abstimmschraube oder dgl. sein. Das Abstimmen kann automatisiert oder manuell erfolgen. Das Mittel zum Messen von Streuparameterdaten kann ein Netzwerkanalysator sein. Die Mittel zum Approximieren, Erstellen der Koppelmatrizen können ein oder mehrere Rechner/Computer sein.

Gemäß einem weiteren Aspekt kann ein Computerprogrammprodukt mit Computerprogrammmitteln hier vorgesehen sein, die auf einem computerlesbaren Medium speicherbar sein können und von einem Computer ausführbar sein können, wobei die Computerprogrammmittel ausführbare Anweisungen enthalten können, die den Computer dazu veranlassen können, die Schritte gemäß zumindest einem der vorstehend genannten Verfahrensaspekte auszuführen.

Zusammenfassend wird hier ein Verfahren vorgestellt, das eine gute Konvergenz aufweist, weniger Rechenaufwand erzeugt und die physikalische Struktur des Filters, der abzustimmen ist, mittels einer angepassten Koppelmatrix sehr genau wiedergeben kann. Weiterhin werden eine entsprechende Vorrichtung zum Durchführen des Verfahrens zum Abstimmen des Filters und/oder zum Anpassen der Koppelmatrix und ein entsprechendes Computerprogrammprodukt beschrieben.

Gegenüber reiner Optimierung oder Abstimmung von Hand kann somit mittels der hier beschriebenen Verfahren(s), der Vorrichtung(en) und den entsprechenden Computerprogrammprodukten eine höhere Zuverlässigkeit und Geschwindigkeit des Verfahrens erreicht werden. Dies ermöglicht die Verwendung entsprechender adaptiver Filter in multifunktionalen und/oder kognitiven Funksystemen, in denen eingebaute elektrische oder mechanische Abstimmelemente automatisch in quasi-Echtzeit den Anforderungen der Anwendung angepasst werden. In Anwendungen der Filterabstimmung kann nach der Fertigung durch reduzierten Zeitbedarf eine höhere Produktivität erreicht werden. Durch die allgemeine Einsetzbarkeit des Verfahrens fällt der Aufwand für vorheriges Training eines spezialisierten Algorithmus (wie z.B. bei neuronalen Netzen) weg. Das Verfahren ist auch für verlustbehaftete Filter einsetzbar.

Das hier dargelegte Verfahren und die dazugehörige Vorrichtung/Computerprogrammprodukt werden im Folgenden exemplarisch mit Bezug auf die beigefügten, schematischen Zeichnungen beschrieben. Es zeigen

Fig. 1    die beispielhafte Struktur eines Filter mit drei Resonatoren und einem Eingangs- und Ausgangstor (Fig. 1a), sowie eine Darstellung des Strukturgraphen aus Fig. 1a als Parametersatz in Form einer Matrix (Fig. 1b),

Fig. 2    ein Verfahren zur Abstimmung eines Filters,

Fig. 3a    ein Verfahren zur Rekonfiguration einer Koppelmatrix während eines Abstimmungsverfahrens,

Fig. 3b    ein Verfahren zur Rekonfiguration einer Koppelmatrix während eines Abstimmungsverfahrens, und

Figs. 4 und 5    Anwendungsbeispiele eines Abstimmungsverfahrens.

Im Folgenden werden verschiedene Beispiele detailliert und unter Bezugnahme auf die Figuren beschrieben.

Gleiche bzw. ähnliche Elemente in den Figuren werden hierbei mit gleichen Bezugszeichen bezeichnet. Die vorliegende Vorrichtung und die Verfahren sind jedoch nicht auf die beschriebenen Kombinationen von Merkmalen begrenzt. Vielmehr sollen auch weitere Modifikationen und Kombinationen von Merkmalen verschiedener Beispiele im Rahmen des Schutzumfangs der unabhängigen Ansprüche umfasst sein.

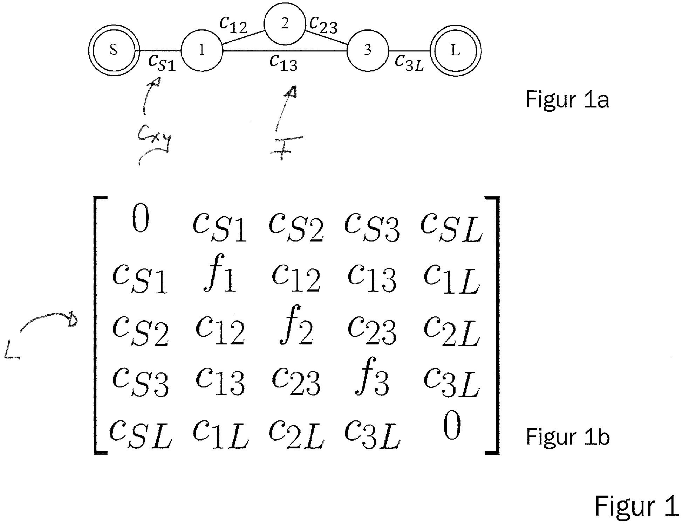

Fig. 1a zeigt zunächst allgemein die Struktur eines Filters F, beispielhaft mit drei Resonatoren (Knoten 1, 2 und 3). Diese Resonatoren sind untereinander mit der Koppelstärke $c_{xy}$ verkoppelt (eingezeichnete Kanten). Der Filter F ist über die Ein- und Ausgangstore (Knoten S=Quelle und L=Last) mit der Umgebung verbunden.

Der Strukturgraph lässt sich äquivalent als Parametersatz in Form einer Matrix darstellen, die sog. Koppelmatrix L. Figur 1b zeigt eine Koppelmatrix L, die den Strukturgraph der Figur 1a entsprechend abbildet. Die Diagonaleinträge f1 bis f3 beschreiben hier eine mögliche Abweichung der Resonanzfrequenz des Resonators von der Mittenfrequenz. Die Einträge können auch gleich "0" sein. Weiterhin ist ersichtlich, dass die entsprechenden Kopplungen bzw. Koppelstärken $c_{xy}$ der Figur 1a in der Matrix elementweise eingetragen sind.

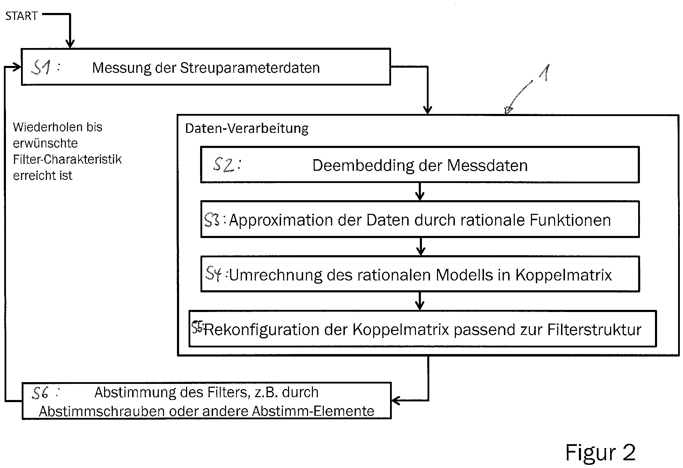

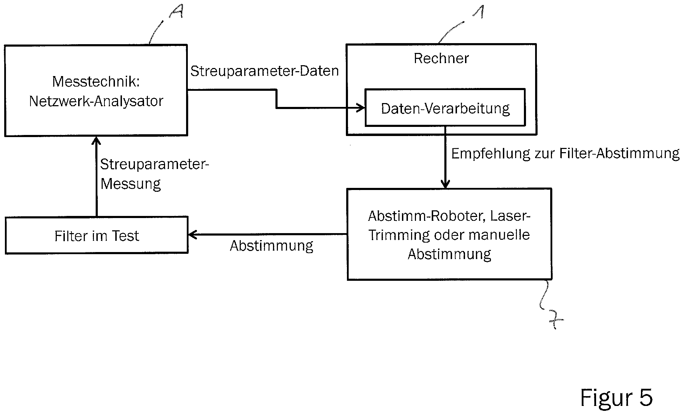

Figur 2 zeigt nun beispielhaft eine Abfolge von Schritten bzw. einen Prozess zur Abstimmung eines Filters F. Dieses Verfahren enthält zudem ein Verfahren zur Erstellung einer Koppelmatrix M, die die Topologie des Filters F wiederspiegelt. Zunächst werden hier zum Start des Verfahrens, das bevorzugt als eine Schleife aufgebaut sein kann, die Streuparameterdaten gemessen (Schritt S1). Beispielsweise kann dazu ein Netzwerkanalysator A (s. Figur 5) herangezogen werden, mit dem der abzustimmende Filter F vermessen wird.

Anschließend werden die gemessenen Streuparameterdaten in eine Vorrichtung zur Datenverarbeitung, bspw. einen Rechner 1 (s. Figur 5), eingegeben. Dies kann über eine Datenleitung oder Funkverbindung erfolgen oder auch manuell, z.B. mittels Transport und Überspielen auf/von einem Speichermittel. Die Datenverarbeitung umfasst dann, wie beispielhaft in Figur 2 gezeigt wird, zunächst einen Schritt S2, der als "Deembedding" der Messdaten bezeichnet wird. Die gemessenen Streuparameterdaten können Zeitverzögerungen enthalten, die von einer Zeitverzögerungen an den Toren des Filters stammen können. Mittels "Deembedding" können diese Zeitverzögerungen entfernt werden. Das "Deembedding" kann mittels bekannter Verfahren durchgeführt werden und erfolgt bevorzugt in den Fällen, in denen Modelle rationaler Funktionen mit niedriger Ordnung in Schritt S3 herangezogen werden, da diese Modelle Zeitverzögerungen nicht zuverlässig abbilden können.

In einem weiteren Schritt S3 erfolgt dann die bereits angesprochene Abbildung bzw. Approximation der Streuparameterdaten mittels rationaler Funktionen. Beispielsweise können für die Beschreibung der Messdaten mittels rationaler Funktionen zunächst Y-Parameter aus den Streuparameterdaten gewonnen werden, aus denen dann mittels rationaler Approximation die rationalen Funktionen ermittelt werden können. Ein vorbekannter und bevorzugt in Schritt S3 verwendeter Algorithmus für die rationale Approximation ist der "Vektor Fitting Algorithm" (bspw. B. Gustavsen und A. Semlyen, "Rational approximation of frequency domain responses by vector fitting", IEEE Trans. Power Del., vol. 14, no. 3, 1999). Andere Algorithmen bzw. Verfahren können ebenfalls herangezogen werden.

Nachdem die rationalen Funktionen aufgestellt wurden, wird der Schritt S4 ausgeführt, der eine Umrechnung des rationalen Modells/Funktionen in eine ursprüngliche Koppelmatrix L vorsieht. Diese Umrechnung bzw. die Extraktion der ursprünglichen Koppelmatrix L kann bevorzugt mittels dem von V. Miraftab et. al. in "Generalized lossy microwave filter coupling matrix synthesis and design using mixed technologies" in IEEE Transcations on Microwave theory and techniques, vol. 56, no. 12, December 2008 beschriebenen Verfahren erfolgen. Andere Algorithmen bzw. Verfahren können auch herangezogen werden.

Das Ergebnis des Schrittes S4 ist somit die ursprüngliche Koppelmatrix L, die jedoch noch nicht die physikalische Struktur des abzustimmenden Filters wiederspiegelt und deshalb noch nicht zum hochgenauen Abstimmen/Einstellen eines Filters geeignet ist. Deshalb schließt sich verfahrensgemäß ein weiterer Schritt S5 an, der eine Anpassung/Rekonfiguration der ursprünglichen Koppelmatrix L vorsieht. Der Schritt S5 ermöglicht es, dass die abzubildende physikalische Filterstruktur sehr genau wiedergegeben werden kann.

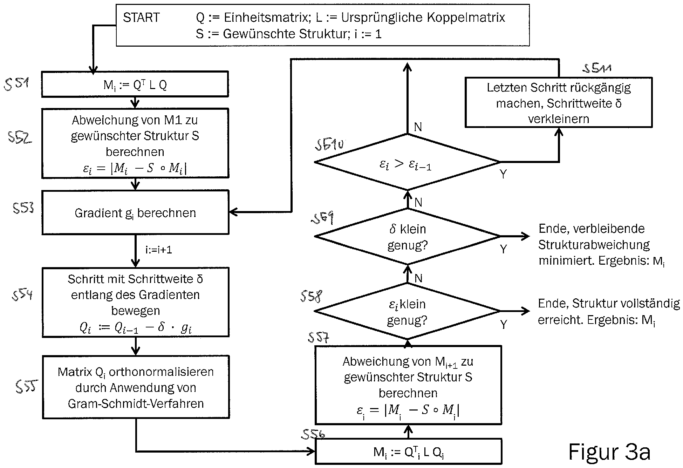

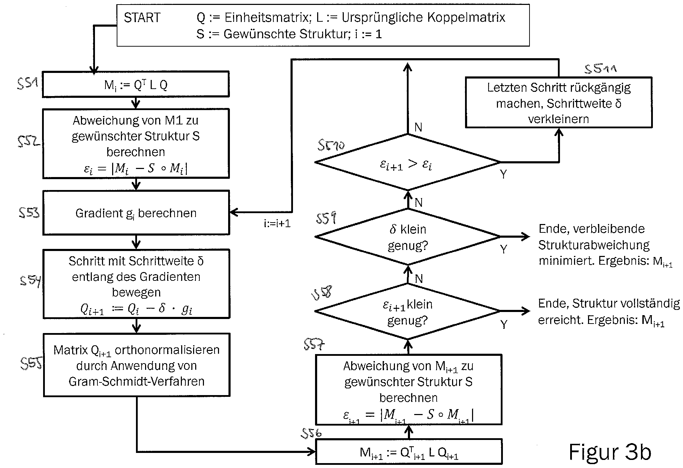

Der Schritt S5 umfasst mehrere Unterschritte, die vor dem Hintergrund der Figuren 3a und 3b unten im Detail erläutert werden sollen.

Nach dem Schritt S5 liegt eine Koppelmatrix M vor, die die physikalische Struktur des abzustimmenden Filters F sehr genau wiederspiegelt, so dass dann im Schritt S6 das Abstimmen des Filters F erfolgen kann. Dies kann automatisiert oder von Hand erfolgen, z.B. können dazu Abstimmschrauben als Abstimmmittel verwendet werden.

Das Verfahren zur Abstimmung des Filters F sieht nach dem Schritt S6 optional vor, dass die vorbeschriebenen Schritte in einer Schleife so lange weiter durchgeführt werden, bis eine vorbestimmte erwünsche Filter-Charakteristik erreicht worden ist. Es kann allerdings auch bestimmt sein, dass nur ein Durchlauf der Schritte S1-S6 erfolgen soll, insbesondere wenn eine besonders kurze Abstimmdauer priorisiert werden soll.

Nachfolgend werden nun die Unterschritte des Schrittes S5 der Figur 2 anhand der Figur 3a näher beleuchtet, die, wie Figur 3a zeigt, in einer Schleife angeordnet sind, so dass die Anpassung des Anpassung der Koppelmatrix $M_i$ iterativ erfolgen kann. Zum Start werden eine erste Ähnlichkeitstransformationsmatrix $Q_1$, eine Strukturmatrix S, die die vorbestimmte gewünschte physikalische Struktur des Filters abbildet, und die ursprüngliche und umzuformende Koppelmatrix L übergeben. In Schritt S51 wird zum Start des Verfahrens gemäß Schritt S5 eine Koppelmatrix $M_i$ mit "i"=1

definiert. Nach dem Start ist die erste Koppelmatrix $M_i$ folglich die erste (Modifikation der) Koppelmatrix $M_1$. Schritt S51 umfasst eine Matrixzerlegung von L gemäß (1):

$$M_i := Q_i^T L Q_i.$$

Die Zerlegung im ersten Schritt, bei i=1, erfolgt bevorzugt, und wie das Feld "Start" in Figur 2 anzeigt, so, dass $Q_1$ die Einheitsmatrix I ist und L die zuvor in Schritt S4 aufgestellte ursprüngliche Koppelmatrix L. Damit entspricht $M_1$ der ursprüngliche Koppelmatrix L. Die Matrixzerlegung kann auch abweichend davon durchgeführt werden. Bspw. kann die erste Ähnlichkeitstransformationsmatrix $Q_1$ auch so berechnet werden, dass sie die Eigenvektoren der ursprünglichen Koppelmatrix L aufweist.

Die Zerlegung bringt den Vorteil mit sich, dass eine nachfolgende Minimierung einer Strukturwertabweichung $\varepsilon_i$ der Koppelmatrix M basierend auf einer Änderung der Ähnlichkeitstransformationsmatrix $Q_i$ erfolgt. Die ursprüngliche Koppelmatrix L, die in Schritt S4 erstellt wurde, wird hingegen nicht geändert. Die Ähnlichkeitstransformationsmatrix $Q_i$ ist dabei so geformt, dass die Streuparameterdaten während der Minimierung der Strukturabweichung $\varepsilon_i$ nicht geändert werden. Der Rechenaufwand kann folglich erheblich reduziert werden, die Entstehung einer Vielzahl lokaler Minima kann verhindert werden und gleichzeitig können sehr genauen Ergebnissen bei der Abbildung der physikalischen Struktur des Filters F erzielt werden.

Die genannte Strukturabweichung $\varepsilon_i$ wird erstmals im Schritt S52 ermittelt; und zwar basierend auf der Gleichung (2)

$$\varepsilon_i := |M_i - S \circ M_i|,$$

wobei S die (Struktur-)Matrix ist, die die gewünschte physikalische Struktur des Filters F wiedergibt. Diese Matrix S enthält "0"-Elemente an den Stellen, an denen die Elemente der Matrix M verschwinden sollen. Die übrigen Elemente enthalten "1". Das gezeigte Produkt ist ein elementweises Produkt und die oben gezeigte Gleichung (2) ergibt einen Skalar, die Strukturabweichung $\varepsilon_i$, die die Abweichung der aktuellen Koppelmatrix $M_i$ gegenüber der zu erreichenden Struktur S anzeigt. Die Strukturabweichung $\varepsilon_i$ soll im weiteren Durchlauf des Schrittes S5 minimiert werden.

Die Minimierung der Strukturabweichung $\varepsilon_i$ erfolgt mittels eines Gradientenverfahrens, das in den Figuren 3a und 3b gezeigt ist. Dazu wird zunächst

in einem Schritt S53 der aktuelle Gradient $g_i$ der aktuellen Ähnlichkeitstransformationsmatrix $Q_i$ berechnet. Der Begriff "aktuell" soll insbesondere den Wert eines "aktuellen Iterationsdurchlaufes" des Schrittes S5 bezeichnen bzw. in Figur 3a den Wert mit dem Index "i". Die Berechnung des Gradienten $g_i$ erfolgt basierend auf den Gleichungen (3)-(5):

$$g_i = \frac{1}{2} Q_i \left( Q_i^T f - f^T Q_i \right)$$

wobei (4): $f_{m,n} = 2 Spur((M - S \circ M) \cdot (V - S \circ V))$ und (5): $V = Q_i^T L J^{m,n} + J^{n,m} L Q_i$.

Die Gleichung (3) benötigt neben der aktuellen Ähnlichkeitstransformationsmatrix $Q_i$ eine Matrix f. Die Matrix f enthält die Elemente $f_{m,n}$, die gemäß Gleichung (4) zu berechnen sind. Die Gleichung (4) zur Berechnung von $f_{m,n}$ wird entsprechend so häufig durchgeführt, wie die Anzahl der Elemente der Matrix f ist. Bei einer N*N-Matrix wäre dies z.B. $N^2$-mal. Die Matrix V der Gleichung (5) stellt eine Hilfsgröße dar, die der Einfachheit halber mit V statt $V_i$ angegeben wird. Ferner ist anzumerken, dass L die ursprüngliche Koppelmatrix ist und in Gleichung (4) die aktuelle Matrix $M_i$ der Einfachheit halber mit M angegeben wird. S ist die (Struktur-)Matrix der zu erreichenden physikalischen Filterstruktur. Die Matrix $J^{m,n}$ ist so aufgebaut, dass außer dem m,n-Element, das "1" ist, alle weiteren Elemente "0" sind.

Die Gleichung (3) gemäß Schritt S53 liefert somit eine Aussage darüber, in welche Richtung die Ähnlichkeitstransformationsmatrix $Q_i$ angepasst werden soll. Basierend auf dieser Information wird dann im Schritt S54 eine Änderung der Ähnlichkeitstransformationsmatrix $Q_i$ durchgeführt. Schritt S54 der Figur 3 zeigt hier die Anpassung basierend auf einer zuvor gültigen Ähnlichkeitstransformationsmatrix $Q_{i-1}$, wenn i vor dem Schritt S54 um den Wert "1" erhöht worden ist. Im ersten Durchlauf und basierend auf dem Beispiel gemäß Figur 3 wäre die Ähnlichkeitstransformationsmatrix $Q_{i-1}$ die beim Start von Schritt S5 übergebene/eingegebene Einheitsmatrix I. Die Gleichung (6) zum Ändern der Ähnlichkeitstransformationsmatrix $Q_i$ lautet:

$$Q_i := Q_{i-1} - \delta \cdot g_i.$$

In Gleichung (6) ist $\delta$ eine Schrittweite, die ebenfalls vorgegeben bzw. vorbestimmt sein kann. Ein Anwender kann einen Wert für die Schrittweite jedoch auch manuell eingeben können. Der Wert der Schrittweite kann zum Start von Schritt S5 bzw. S54 bevorzugt beliebig gewählt/gesetzt werden.

An den Schritt S54 kann sich der Schritt S55 anschließen, der eine Orthonormalisierung der Ähnlichkeitstransformationsmatrix $Q_i$ durchführt, die nach der Anpassung dieser in Schritt S54 notwendig und/oder von Vorteil sein kann, um die Genauigkeit des Verfahrens gemäß Schritt S5 zu erhöhen. Bevorzugt wird das Gram-Schmidt-Verfahren im Schritt S55 angewendet.

Figur 3a zeigt nun, dass eine zweite Modifikation der Koppelmatrix $M_i$ (i=2) in Schritt S56 berechnet wird, wiederrum basierend auf der ursprünglich erstellten Koppelmatrix L, die für das hier beschriebene Verfahren nicht verändert wird, und basierend auf der zuvor angepassten Ähnlichkeitstransformationsmatrix $Q_i$. Wenn das Verfahren gemäß Schritt S5 mit der Einheitsmatrix I als Matrix $Q_1$ startet, so würde die Koppelmatrix $M_2$ basierend auf der einmal modifizierten Einheitsmatrix I, der Ähnlichkeitstransformationsmatrix $Q_2$, ermittelt. Die Gleichung entspricht dabei der Gleichung (1) aus Schritt S51. Die neu ermittelte Koppelmatrix $M_2$ wird anschließend in Schritt S57 analog zu Schritt S52 herangezogen, um die geänderte Strukturabweichung $\varepsilon_2$ zu berechnen, s. dazu die Gleichung (2).

Danach schließt sich gemäß dem beispielhaften Ablauf der Figur 3a ein Abfragen an, das dazu dient, festzustellen, ob das Verfahren bereits ein befriedigendes Minimierungsergebnis für die Strukturabweichung $\varepsilon$ ergeben hat oder ob weitere Durchläufe notwendig sind. Dazu wird in einer ersten Abfrage in Schritt S58 geprüft, ob die soeben ermittelte Strukturabweichung $\varepsilon_i$, die aktuelle, klein genug ist. Bevorzugt erfolgt dies mittels eines Vergleiches zwischen der aktuellen Strukturabweichung $\varepsilon_i$ und einem vorbestimmten Grenzwert $\varepsilon_{Grenz}$. Liegt die aktuelle Strukturabweichung $\varepsilon_i$ darunter, so kann festgestellt werden, dass die gewünschte Struktur der Koppelmatrix erreicht worden ist und das Verfahren gemäß Schritt S5 kann beendet werden.

Andernfalls folgt ein Prüfschritt S59, der abfragt, ob die (aktuelle) Schrittweite $\delta$ klein genug gewählt worden war. Auch dazu wird bevorzugt ein Vergleich mit einem Grenzwert $\delta_{Grenz}$ herangezogen. Ist die Schrittweite $\delta$ kleiner als der Grenzwert $\delta_{Grenz}$ so wurde ein lokales Minimum erreicht und die verbleibende Strukturabweichung kann beibehalten bleiben. Das Verfahren gemäß Schritt S5 kann beendet werden.

Andernfalls, falls auch Schritt S59 ein negatives Prüfergebnis ergibt, folgt ein Schritt S510, mit dem ein zuvor gültiger Wert der Strukturabweichung $\varepsilon_{i-1}$ mit dem aktuellen Wert $\varepsilon_i$ verglichen wird. Figur 3 zeigt hier beispielhaft den Vergleich von $\varepsilon_2$ mit $\varepsilon_1$. Ist der aktuelle Wert, hier $\varepsilon_2$, größer, so kann gemäß Schritt S511 die Schrittweite $\delta$ verkleinert werden. Bevorzugt gibt ein Anwender beliebig vor, wie die Verkleinerung erfolgen soll. Die Rechenvorschrift für die Verkleinerung kann jedoch auch vorgespeichert sein und die Verkleinerung somit automatisiert durchgeführt werden. Weiterhin kann Schritt S511 umfassen, dass die Ähnlichkeitstransformationsmatrix wieder zurückgesetzt wird; und zwar auf die zuvor gültige mit Index "i-1", d.h. der zuletzt durchgeführte Schritt S54 kann rückgängig gemacht werden. Anschließend kann dann eine neu modifizierte Ähnlichkeitstransformationsmatrix $Q_i$ mittels der verkleinerten Schrittweite $\delta$ in Schritt S54 errechnet werden.

Falls der aktuelle Wert der Strukturabweichung $\varepsilon_i$ jedoch kleiner als der vorangegangene sein sollte, so schließt sich an den Schritt S510 ein weiterer Durchlauf startend mit Schritt S53 an, wobei "i" nach der Neuberechnung des Gradienten in Schritt S53 um den Wert "1" erhöht werden kann.

Falls der Gradient g der Gradient des ersten Durchlaufes, d.h. $g_1$, konstant bleiben soll, so können weitere Durchläufe mit S54 starten. Die Schrittweite kann konstant beibehalten werden, falls nicht eine Anpassung gemäß Schritt S511 für notwendig erachtet werden sollte.

Weiterhin zeigt Figur 3b eine Abwandlung des Verfahrens gemäß Schritt S5, wobei die Abwandlung insbesondere darin besteht, dass der Index "i" zu einem anderen Zeitpunkt bzw. an einer anderen Stelle im Verfahren erhöht wird. So zeigt die Figur 3b, dass der Index "i" bereits vor der Berechnung des Gradienten, d.h. vor Schritt S53, und nach den Prüfungen gemäß den Schritten S58-S510 erhöht wird. Entsprechend wurden die Indizes der verwendeten Gleichungen angepasst, wie Figur 3b ebenfalls zeigt.

Andere Abwandlungen bzw. Abweichungen von der Abfolge der Schritte je Durchlauf können optional auch möglich sein, solange eine Minimierung der Strukturabweichung $\varepsilon_i$ mittels der Abänderung der Ähnlichkeitstransformationsmatrix $Q_i$, wie beschrieben, erfolgt und der Erfolg dieser Minimierung regelmäßig geprüft wird, z.B. in jedem Iterationsdurchlauf, in jedem zweiten oder dgl. Bei Abwandlungen der Abfolge können Änderungen der Gleichungen, insbesondere im Hinblick auf die verwendeten Indizes, notwendig sein, so wie dies beispielhaft für die Abwandlung gemäß Figur 3b in Figur 3b vorgeführt wird.

Der Schritt S5 mit seinen oben beschriebenen Unterschritten kann bevorzugt von einer dazu eingerichteten Vorrichtung, z.B. einem Rechner 1 und/oder einem Computerprogrammprodukt ausgeführt werden. Der Rechner 1 kann dazu Mittel aufweisen, die die entsprechende Datenverarbeitung 1c ausführen können. Bevorzugt sind diese Mittel 1c Rechenmodule, die die Datenverarbeitung gemäß Schritten S2-S5 automatisiert durchführen können. An den Rechner 1 kann ein Abstimmroboter 7 oder dgl. angeschlossen sein, der die Abstimmung des Filters F basierend auf der angepassten Koppelmatrix M ausführt. Figur 5 zeigt ein beispielhaftes System mit Messtechnik zur Vermessung des Filters F, z.B. einem Netzwerkanalysator A. Die Messtechnik kann die erfassten Streuparameterdaten automatisch an den Rechner 1 übermitteln, der dazu eingerichtet ist, die Schritte S2-S4 auszuführen. Der Rechner 1 kann bspw. unmittelbar nach Erhalt der Messdaten die Schritte S2-S4 ausführen. Der Rechner 1 kann danach an ein mit Signal- und/oder Datenleitung an den Rechner 1 angeschlossenes Abstimmmittel 7 eine Empfehlung für die Abstimmung des Filters F weitergegeben. Diese Empfehlung beinhaltet zumindest die anpasste Koppelmatrix M als Ergebnis des Schrittes S5. Mittels des Abstimmmittels 7 (z.B. ein Abstimmroboter oder eine Lasertrimmingeinrichtung) und/oder manuellem Abstimmen wird der Filter F dann abgestimmt und danach neu vermessen, wie Figur 5 weiter zeigt. Der in Figur 5 mittels den Pfeilen gezeigte Ablauf innerhalb des Abstimmsystems kann iterativ erfolgen. Es kann auch vorgesehen sein, dass nach dem ersten Durchlauf der Schleife gemäß Figur 5 abgebrochen wird.

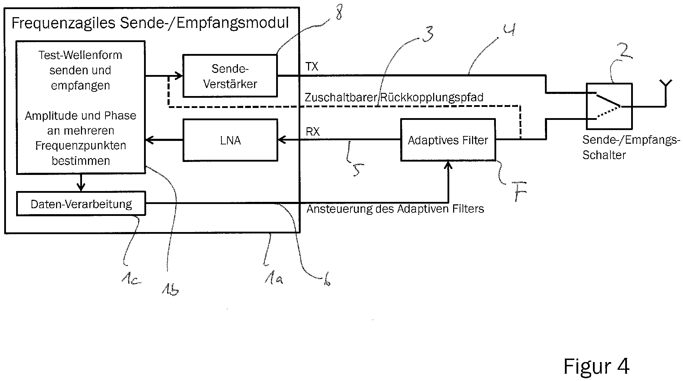

Ein Anwendungsbeispiel des hier beschriebenen Verfahrens bzw. der entsprechenden Vorrichtung/System wird von Figur 4 aufgezeigt. So zeigt die Figur 4 die Verwendung eines adaptiven Filters F in einem multifunktionalen Funksystem, in dem eingebaute elektrische oder mechanische Abstimmelemente automatisch in quasi-Echtzeit den Anforderungen der Anwendung angepasst werden. Konkret zeigt die Figur 4 beispielhaft, dass ein frequenzagiles Sende-/Empfangsmodul 1a ein Mittel 1b aufweist, das Test-Wellenformen über einen optionalen Sendeverstärker 8 an einen Sende-/Empfangsschalter 2 senden kann. Dies erfolgt gemäß Figur 4 über eine erste Datenverbindung 4. Daten/Signale, die von dem Sende-/Empfangsschalter 2 empfangen werden, können über eine zweite Datenverbindung 5 von dem Sende-/Empfangsmodul 1a empfangen werden. Dazu werden diese über einen adaptiven Filter F geleitet und optional auch über einen rauscharmen Verstärker LNA. Das Mittel 1b ist ferner dazu eingerichtet, die Amplitude und Phase der empfangenen Signale an mehreren Frequenzpunkten zu bestimmen und diese Informationen an ein Datenverarbeitungsmittel 1c weiterzugeben. Das Datenverarbeitungsmittel 1c führt die Schritte gemäß dem hier beschriebenen Verfahren, insbesondere S2-S5, bevorzugt S5, aus und passt über eine dritte Datenverbindung 6 den adaptiven Filter F an - insbesondere gemäß den Ergebnissen des Schrittes S5. Ferner kann auch ein Rückkoppelpfad 3 zwischen der ersten Datenverbindung 4 zuschaltbar vorgesehen sein, der bevorzugt zwischen einer Position vor (in Signalflussrichtung) dem Sendeverstäker 8 und vor (in Signalflussrichtung) dem adaptiven Filter F verläuft. Der Aufbau zusammen mit dem hier beschriebenen Verfahren/Vorrichtung erlaubt es somit, dass der adaptive Filter F automatisch in quasi-Echtzeit den Anforderungen der Anwendung angepasst werden kann.

Eine weitere Anwendung der hier beschriebenen Verfahren/Vorrichtungen erlaubt z.B. eine Abstimmung eines Filter F nach dessen Fertigung, insbesondere mit reduziertem Zeitbedarf und damit höherer Produktivität.

Abschließend kann zusammengefasst werden, dass durch die allgemeine Einsetzbarkeit der hier beschriebenen Verfahren, der Vorrichtung und des Computerprogrammproduktes der Aufwand für ein vorangehendes Training eines spezialisierten Algorithmus' (z.B. neuronales Netz) wegfällt. Verlustbehaftete Filter können abgestimmt werden. Es kann zudem ein Parametersatz mit beliebiger Struktur so umgeformt werden, dass dieser mit dem physikalischen Aufbau des Filters vergleichbar ist. Dadurch können robustere und schnellere Verfahren zur Parameterextraktion angewandt werden.

## Patentansprüche

1. Verfahren zum Erstellen einer angepassten Koppelmatrix (M) zum Abbilden einer physikalischen Struktur eines Filters (F) umfassend

   - Messen von Streuparameterdaten des Filters (F),
   - Approximation der gemessenen Streuparameterdaten mittels rationaler Funktionen,
   - Erstellen einer ursprünglichen Koppelmatrix (L) basierend auf den rationalen Funktionen, und
   - iteratives Erstellen einer angepassten Koppelmatrix (M), die die physikalische Struktur des Filters (F) abbildet, basierend auf der ursprünglichen Koppelmatrix (L), **gekennzeichnet dadurch, dass** beim iterativen Erstellen, eine Strukturabweichung ($\varepsilon$), die eine Abweichung zwischen der Koppelmatrix (M) und einem elementweisen Produkt einer Strukturmatrix (S) und der Koppelmatrix (M) angibt, iterativ minimiert wird, wobei die Strukturmatrix (S), die vorgegeben ist, die physikalische Struktur des Filters (F) darstellt.

2. Verfahren gemäß einem der vorangehenden Ansprüche, wobei der Schritt des Erstellens der angepassten Koppelmatrix (M) die folgenden Schritte umfasst:

   - Ermitteln einer aktuellen Iterationslösung der angepassten Koppelmatrix (M) basierend auf einer aktuellen Ähnlichkeitstransformationsmatrix (Q) und einer ursprünglichen Koppelmatrix (L), und
   - Ermitteln einer aktuellen Iterationslösung der Strukturabweichung ($\varepsilon$).

3. Verfahren gemäß Anspruch 2, weiter umfassend

- Vergleichen der aktuellen Iterationslösung der aktuellen Strukturabweichung ($\varepsilon$) mit einem vorbestimmter Grenzwert ($\varepsilon_{Grenz}$),
- Vergleichen einer Schrittweite ($\delta$) zur Berechnung der Ähnlichkeitstransformationsmatrix (Q) mit einem vorbestimmten Grenzwert ($\delta_{Grenz}$),
- Abfragen, ob die aktuelle Strukturabweichung ($\varepsilon$) größer ist als eine Strukturabweichung ($\varepsilon$) des vorangegangenen Iterationsschrittes, wenn die aktuelle Strukturabweichung ($\varepsilon$) größer als der vorbestimmter Grenzwert ($\varepsilon_{Grenz}$) ist und die Schrittweite ($\delta$) größer ist als der vorbestimmte Grenzwert ($\delta_{Grenz}$), und
- Zurücksetzen einer Ähnlichkeitstransformationsmatrix auf die des vorangegangenen Iterationsschrittes und Verkleinern der Schrittweite ($\delta$), wenn die aktuelle Strukturabweichung ($\varepsilon$) größer ist als die Strukturabweichung ($\varepsilon$) des vorangegangenen Iterationsschrittes.

4. Verfahren gemäß Anspruch 3, wobei die Iteration beendet wird, wenn eine aktuelle Strukturabweichung ($\varepsilon$) kleiner als der vorbestimmte Grenzwert ($\varepsilon_{Grenz}$) ist oder die Schrittweite ($\delta$) kleiner als der vorbestimmte Grenzwert ($\delta_{Grenz}$) ist.

5. Verfahren gemäß Anspruch 2, wobei ab i $\geq$ 2 eine aktuelle Ähnlichkeitstransformationsmatrix (Q) basierend auf einem aktuellen Gradienten (g) und einer vorbestimmten Schrittweite ($\delta$) mittels $Q_i := Q - \delta \cdot g$ ermittelt wird, wobei Q die vormals aktuelle Ähnlichkeitstransformationsmatrix und das Ergebnis der Gleichung die neue aktuelle Ähnlichkeitstransformationsmatrix angeben.

6. Verfahren gemäß Anspruch 2, wobei eine erste Iterationslösung der Koppelmatrix (M₁) mittels einer ersten Ähnlichkeitstransformationsmatrix (Q₁) ermittelt wird, die aus einer Matrixzerlegung der ursprünglichen Koppelmatrix (L) resultiert, wobei die erste Ähnlichkeitstransformationsmatrix (Q₁) die Form $\begin{bmatrix} 1 & 0 & \ldots & 0 & 0 \\ 0 & & & & 0 \\ \vdots & & Q^T_{INNEN} & & \vdots \\ 0 & & & & 0 \\ 0 & 0 & \ldots & 0 & 1 \end{bmatrix}$ aufweist.

7. Verfahren gemäß Anspruch 2, wobei für die Ermittlung der ersten Iterationslösung der Koppelmatrix (M₁) die Einheitsmatrix (I) als erste Ähnlichkeitstransformationsmatrix (Q₁) vorgegeben wird.

8. Verfahren gemäß Anspruch 2, wobei für die Ermittlung der ersten Iterationslösung der Koppelmatrix (M₁) die ursprüngliche Koppelmatrix (L) mittels einer verallgemeinerten Eigenwertzerlegung zerlegt wird.

9. Verfahren gemäß Anspruch 5, wobei nach Ermittlung einer neuen aktuellen Ähnlichkeitstransformationsmatrix (Q) eine Orthonormalisierung dieser Ähnlichkeitstransformationsmatrix (Q) durchgeführt wird.

10. Verfahren nach zumindest einem der voranstehenden Ansprüche, wobei die Strukturabweichung ($\varepsilon$) mittels $\varepsilon := |M - S \circ M|$ ermittelt wird, wobei der Operator "$\circ$" ein elementweises Produkt bezeichnet.

11. Verfahren zum Abstimmen eines Filters basierend auf einer angepassten Koppelmatrix (M), die mittels eines Verfahrens nach zumindest einem der voranstehenden Ansprüche erstellt wurde.

12. Vorrichtung zum Abstimmen eines Filters mittels einer Koppelmatrix (L, M), mit

- einem Mittel zum Messen von Streuparameterdaten des Filters (F),
- einem Mittel zum Approximieren der gemessenen Streuparameterdaten mittels rationaler Funktionen,
- einem Mittel zum Erstellen einer Koppelmatrix (L) basierend auf den rationalen Funktionen,
- einem Mittel zum iterativen Erstellen einer angepassten Koppelmatrix (M), die die physikalische Struktur des Filters (F) wiedergibt, basierend auf der Koppelmatrix (L), und
- einem Mittel zum Abstimmen des Filters basierend auf der angepassten Koppelmatrix (M),

**gekennzeichnet dadurch, dass**
das Mittel zum iterativen Erstellen eine Strukturabweichung ($\varepsilon$), die eine Abweichung zwischen der Koppelmatrix (M) und einem elementweisen Produkt einer Strukturmatrix (S) und der Koppelmatrix (M) angibt, iterativ minimiert, wobei die Strukturmatrix (S), die vorgegeben ist, die physikalische Struktur des Filters (F) darstellt.

**13.** Computerprogrammprodukt mit Computerprogrammmitteln, die auf einem computerlesbaren Medium speicherbar sind und von einem Computer ausführbar sind, wobei die Computerprogrammmittel ausführbare Anweisungen enthalten, die den Computer dazu veranlassen, die Schritte gemäß zumindest einem der Ansprüche 1-11 auszuführen.

**Claims**

**1.** Method for creating an adapted coupling matrix (M) for reproducing a physical structure of a filter (F), comprising:

- measuring scattering parameter data of the filter (F),
- approximating the measured scattering parameter data using rational functions,
- creating an initial coupling matrix (L) on the basis of the rational functions, and
- iteratively creating an adapted coupling matrix (M) which reproduces the physical structure of the filter (F) on the basis of the original coupling matrix (L),

**characterised in that**
during the iterative creation, a structural deviation ($\varepsilon$) specifying a deviation between the coupling matrix (M) and an element-wise product of a structure matrix (S) and the coupling matrix (M) is iteratively minimised, the structure matrix (S), which is preset, representing the physical structure of the filter (F).

**2.** Method according to any of the preceding claims, wherein the step of creating the adapted coupling matrix (M) comprises the following steps:

- determining the current iterative solution for the adapted coupling matrix (M) on the basis of a current similarity transformation matrix (Q) and an initial coupling matrix (L), and
- determining a current iterative solution for the structural deviation ($\varepsilon$).

**3.** Method according to claim 2, further comprising:

comparing the current iterative solution for the current structural deviation ($\varepsilon$) with a predetermined limit ($\varepsilon_{limit}$),

- comparing a step width ($\delta$) for calculating the similarity transformation matrix (Q) with a predetermined limit ($\delta_{limit}$),
- querying whether the current structural deviation ($\varepsilon$) is greater than a structural deviation ($\varepsilon$) of the preceding iteration step if the current structural deviation ($\varepsilon$) is greater than the preset limit ($\varepsilon_{limit}$) and the step width ($\delta$) is greater than the preset limit ($\delta_{limit}$), and
- resetting a similarity transformation matrix to that of the preceding iteration step and reducing the step width ($\delta$) if the current structural deviation ($\varepsilon$) is greater than the structural deviation ($\varepsilon$) of the preceding iteration step.

**4.** Method according to claim 3, wherein the iteration is ended if a current structural deviation ($\varepsilon$) is less than the predetermined limit ($\varepsilon_{limit}$) or the step width ($\delta$) is less than the preset limit ($\delta_{limit}$).

**5.** Method according to claim 2, wherein starting from i $\geq$ 2 a current similarity transformation matrix (Q) is determined on the basis of a current gradient (g) and a predetermined step width ($\delta$) by $Q_i := Q - d \cdot g$, where Q specifies the previously current similarity transformation matrix and the result of the equation specifies the new current similarity transformation matrix.

**6.** Method according to claim 2, wherein the first iterative solution for the coupling matrix (M1) is determined using a first similarity transformation matrix ($Q_1$) which results from matrix decomposition of the initial coupling matrix (L), the first similarity transformation matrix ($Q_1$) being of the form

$$\begin{bmatrix} 1 & 0 & \dots & 0 & 0 \\ 0 & & & & 0 \\ \vdots & & Q^{T}_{INTERNAL} & & \vdots \\ 0 & & & & 0 \\ 0 & 0 & \dots & 0 & 1 \end{bmatrix}.$$

7. Method according to claim 2, wherein for determining the first iterative solution for the coupling matrix ($M_1$) the unit matrix (I) is preset as the first similarity transformation matrix ($Q_1$).

8. Method according to claim 2, wherein for determining the first iterative solution for the coupling matrix ($M_1$) the initial coupling matrix (L) is decomposed by generalised eigenvalue decomposition.

9. Method according to claim 5, wherein after a new current similarity transformation matrix (Q) is determined said similarity transformation matrix (Q) is orthonormalised.

10. Method according to at least one of the preceding claims, wherein the structural deviation ($\varepsilon$) is determined by $\varepsilon := |M - S \circ M|$, where the operator "$\circ$" denotes an elementwise product.

11. Method for tuning a filter on the basis of an adapted coupling matrix (M) which has been created by a method according to at least one of the preceding claims.

12. Device for tuning a filter using a coupling matrix (L, M), comprising:

- a means for measuring scattering parameter data of the filter (F),
- a means for approximating the measured scattering parameter data using rational functions,
- a means for creating a coupling matrix (L) on the basis of the rational functions,
- a means for iteratively creating an adapted coupling matrix (M) which reproduces the physical structure of the filter (F) on the basis of the original coupling matrix (L), and
- a means for tuning the filter on the basis of the adapted coupling matrix (M),

**characterised in that**
the means for iterative creation iteratively minimises a structural deviation ($\varepsilon$) specifying a deviation between the coupling matrix (M) and an element-wise product of a structure matrix (S) and the coupling matrix (M), the structure matrix (S), which is preset, representing the physical structure of the filter (F).

13. Computer program product comprising computer program means which can be stored on a computer-readable medium and implemented by a computer, the computer program means containing executable instructions which cause the computer to carry out the steps according to at least one of claims 1 - 11.

**Revendications**

1. Procédé d'élaboration d'une matrice de couplage (M) adaptée pour représenter la structure physique d'un filtre (F) comprenant :

- la mesure des données de paramètres de répartition du filtre (F),
- l'approximation des données de paramètres de répartition mesurées par l'utilisation de fonctions rationnelles,
- l'élaboration d'une matrice primitive de couplage (L) sur la base des fonctions rationnelles, et
- l'élaboration itérative d'une matrice de couplage (M) adaptée qui représente la structure physique du filtre (F), sur la base de la matrice primitive de couplage (L),

**caractérisé en ce que**, pendant l'élaboration itérative, une minimisation itérative d'une déviation structurelle ($\varepsilon$) est effectuée, laquelle indique une déviation entre la matrice de couplage (M) et un produit en éléments d'une matrice structurelle (S) et la matrice de couplage (M), la matrice structurelle (S), qui est prédéterminée, représentant la structure physique du filtre (F).

**2.** Procédé selon l'une des revendications précédentes, dans lequel l'étape d'élaboration de la matrice de couplage (M) adaptée, comprend les étapes suivantes :

- la détermination d'une solution actuelle d'itération de la matrice de couplage (M) adaptée, sur la base d'une matrice actuelle de transformation de similitude (Q) et d'une matrice de couplage (L) primitive, et
- la détermination d'une solution itérative actuelle de la déviation structurelle ($\varepsilon$).

**3.** Procédé selon la revendication 2, comprenant en outre la comparaison de la solution itérative actuelle de la déviation actuelle de structure ($\varepsilon$) avec une valeur de seuil prédéterminée ($\varepsilon$seuil),

- la comparaison d'un incrément ($\delta$) pour le calcul de la matrice de transformation de similitude (Q) avec une valeur de seuil prédéterminée ($\delta_{seuil}$),
- l'interrogation quant à savoir si la déviation actuelle de structure ($\varepsilon$) est plus grande qu'une déviation structurelle ($\varepsilon$) de l'étape d'itération en avant, lorsque la déviation actuelle de structure ($\varepsilon$) est plus grande que la valeur de seuil prédéterminée ($\varepsilon_{seuil}$) et l'incrément ($\delta$) est plus grand que la valeur de seuil prédéterminée ($\delta_{seuil}$), et
- le replacement d'une matrice de transformation de similitude sur celle de l'étape d'itération en avant et la diminution de l'incrément ($\delta$), lorsque la déviation actuelle de structure ($\varepsilon$) est plus grande que la déviation structurelle ($\varepsilon$) de l'étape d'itération en avant.

**4.** Procédé selon la revendication 3, dans lequel l'itération se termine lorsqu'une déviation actuelle de structure ($\varepsilon$) est plus petite que la valeur de seuil prédéterminée ($\varepsilon_{seuil}$) ou l'incrément ($\delta$) est plus petit que la valeur de seuil prédéterminée ($\delta$seuil).

**5.** Procédé selon la revendication 2, dans lequel à partir de $i \geq 2$, une matrice actuelle de transformation de similitude (Q) basée sur un gradient actuel (g) et sur un incrément prédéterminé ($\delta$) est déterminée à l'aide de $Q_i := Q - d \cdot g$, où Q indique l'ancienne matrice actuelle de transformation de similitude et le résultat de l'équation indique la nouvelle matrice actuelle de transformation de similitude.

**6.** Procédé selon la revendication 2, dans lequel une première solution itérative de la matrice de couplage (M1) est déterminée en utilisant une première matrice de transformation de similitude ($Q_1$), laquelle résulte d'une décomposition matricielle de la matrice de couplage primitive (L), la première matrice de transformation de similitude ($Q_1$) présentant la formule suivante :

$$\begin{bmatrix} 1 & 0 & ... & 0 & 0 \\ 0 & & & & 0 \\ \vdots & & Q_{INNEN}^{T} & & \vdots \\ 0 & & & & 0 \\ 0 & 0 & ... & 0 & 1 \end{bmatrix}$$

**7.** Procédé selon la revendication 2, dans lequel pour la détermination de la première solution itérative de la matrice de couplage ($M_1$), la matrice unitaire (I) est prédéterminée comme première matrice de transformation de similitude ($Q_1$) .

**8.** Procédé selon la revendication 2, dans lequel pour la détermination de la première solution itérative de la matrice de couplage (M1), la matrice de couplage primitive (L) est décomposée au moyen d'une décomposition en éléments propres généralisée.

**9.** Procédé selon la revendication 5, dans lequel après la détermination d'une nouvelle matrice actuelle de transformation de similitude (Q), une orthonormalisation de ladite matrice de transformation de similitude (Q) est effectuée.

**10.** Procédé selon au moins l'une des revendications précédentes, dans lequel la déviation structurelle ($\varepsilon$) est déterminée au moyen de $\varepsilon := |M - S \circ M|$, où l'opérateur "$\circ$" désigne un produit en éléments.

**11.** Procédé destiné à accorder un filtre sur la base d'une matrice de couplage adaptée (M), élaborée au moyen d'un procédé selon au moins l'une des revendications précédentes.

**12.** Dispositif destiné à accorder un filtre au moyen d'une matrice de couplage (L, M), comportant :

- un moyen de mesure des données de paramètres de répartition du filtre (F),
- un moyen d'approximation des données de paramètres de répartition mesurées au moyen de fonctions rationnelles,
- un moyen d'élaboration d'une matrice de couplage (L) sur la base des fonctions rationnelles,
- un moyen d'élaboration itérative d'une matrice de couplage (M) adaptée, qui reproduit la structure physique du filtre (F), sur la base de la matrice de couplage (L), et
- un moyen d'accord du filtre sur la base de la matrice de couplage adaptée (M),

**caractérisé en ce que** le moyen d'élaboration itérative effectue une minimisation itérative d'une déviation structurelle ($\varepsilon$) qui indique une d'une (D), qui indique une déviation entre la matrice de couplage (M) et un produit en éléments d'une matrice structurelle (S) et la matrice de couplage (M), la matrice structurelle (S), qui est prédéterminée, représentant la structure physique du filtre (F).

**13.** Produit de programme informatique avec moyens de programme informatique, qui peuvent être mémorisés sur un support pouvant être lu par un moyen informatique et qui peuvent être exécutés par un ordinateur, dans lequel les moyens de programme informatique contiennent des instructions exécutables qui permettent à l'ordinateur d'exécuter les étapes selon au moins l'une des revendications 1 à 11.

Figur 1a

$$
\begin{bmatrix}
0 & c_{S1} & c_{S2} & c_{S3} & c_{SL} \\
c_{S1} & f_1 & c_{12} & c_{13} & c_{1L} \\
c_{S2} & c_{12} & f_2 & c_{23} & c_{2L} \\
c_{S3} & c_{13} & c_{23} & f_3 & c_{3L} \\
c_{SL} & c_{1L} & c_{2L} & c_{3L} & 0
\end{bmatrix}
$$

Figur 1b

Figur 1

START

S1 :      Messung der Streuparameterdaten

1

Wiederholen bis
erwünschte
Filter-Charakteristik
erreicht ist

Daten-Verarbeitung

S2 :               Deembedding der Messdaten

S3 : Approximation der Daten durch rationale Funktionen

S4 : Umrechnung des rationalen Modells in Koppelmatrix

S5 Rekonfiguration der Koppelmatrix passend zur Filterstruktur

S6 :      Abstimmung des Filters, z.B. durch
Abstimmschrauben oder andere Abstimm-Elemente

Figur 2

START    Q := Einheitsmatrix; L := Ursprüngliche Koppelmatrix
         S := Gewünschte Struktur; i := 1

S51    $M_i := Q^T L Q$

S52    Abweichung von M1 zu gewünschter Struktur S berechnen
$\varepsilon_i = |M_i - S \circ M_i|$

S53    Gradient $g_i$ berechnen

i:=i+1

S54    Schritt mit Schrittweite δ entlang des Gradienten bewegen
$Q_i := Q_{i-1} - \delta \cdot g_i$

S55    Matrix $Q_i$ orthonormalisieren durch Anwendung von Gram-Schmidt-Verfahren

S510    $\varepsilon_i > \varepsilon_{i-1}$    N / Y

S511    Letzten Schritt rückgängig machen, Schrittweite δ verkleinern

S59    δ klein genug?    N / Y

Ende, verbleibende Strukturabweichung minimiert. Ergebnis: $M_i$

S58    $\varepsilon_i$ klein genug?    N / Y

Ende, Struktur vollständig erreicht. Ergebnis: $M_i$

S57    Abweichung von $M_{i+1}$ zu gewünschter Struktur S berechnen
$\varepsilon_i = |M_i - S \circ M_i|$

S56    $M_i := Q^T_i L Q_i$

Figur 3a

Figur 3b

Frequenzagiles Sende-/Empfangsmodul

| Test-Wellenform senden und empfangen |
| Amplitude und Phase an mehreren Frequenzpunkten bestimmen |

Sende-Verstärker

TX

Zuschaltbarer Rückkopplungspfad

RX

LNA

Adaptives Filter

Sende-/Empfangs-Schalter

Daten-Verarbeitung

Ansteuerung des Adaptiven Filters

Figur 4

A

Messtechnik:
Netzwerk-Analysator

Streuparameter-Daten →

1

Rechner

Daten-Verarbeitung

↑ Streuparameter-
Messung

Filter im Test

← Abstimmung

Empfehlung zur Filter-Abstimmung
↓

Abstimm-Roboter, Laser-
Trimming oder manuelle
Abstimmung

7

# Figur 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

• US 2006202775 A1

• US 2009121802 A1

**In der Beschreibung aufgeführte Nicht-Patentliteratur**

• **J. J. MICHALSKI.** Artificial Neural Networks Approach in Microwave Filter Tuning. *Progress In Electromagnetics Research M,* 2010, vol. 13
• **S. AMARI.** Adaptive Synthesis and Design of Resonator Filters with Source/Load-Multiresonator Coupling. *IEEE Transcations on Microwave theory and techniques,* August 2002, vol. 50 (8
• Generalized lossy microwave filter coupling matrix synthesis and design using mixed technologies. *IEEE Transcations on Microwave theory and techniques,* Dezember 2008, vol. 56 (12
• **B. GUSTAVSEN ; A. SEMLYEN.** Rational approximation of frequency domain responses by vector fitting. *IEEE Trans. Power Del.,* 1999, vol. 14 (3

• **V. MIRAFTAB ; M. YU.** Advanced Coupling Matrix and Admittance Function Synthesis Techniques for Dissipative Microwave Filters. *IEEE TRANSACTIONS ON MICROWAVE THEORY AND TECHNIQUES,* Oktober 2009, vol. 57 (10), 2429-2438
• **V. MIRAFTAB.** Generalized lossy microwave filter coupling matrix synthesis and design using mixed technologies. *IEEE Transcations on Microwave theory and techniques,* Dezember 2008, vol. 56 (12